# FASCICULE DE BREVET EUROPEEN

(11) **EP 2 165 403 B1**
(45) Date de publication et mention de la délivrance du brevet: **28.08.2019**
(21) Numéro de dépôt: 08783144.2
(22) Date de dépôt: 20.06.2008
(51) Int. Cl.: G01R 31/08, H02J 13/00, H02J 3/20

(54) **APPAREIL ET MÉTHODE DE SURVEILLANCE D'UNE LIGNE DE PHASE D'UN TRONÇON D'UNE LIGNE DE TRANSPORT D'ÉNERGIE ÉLECTRIQUE**
ANWENDUNG UND VERFAHREN ZUR ÜBERWACHUNG EINER PHASENLEITUNG EINES TEILS EINER STROMGITTERLEITUNG
APPLIANCE AND METHOD FOR MONITORING A PHASE LINE OF A SECTION OF AN ELECTRICAL ENERGY GRID LINE

(30) Priorité: 21.06.2007 CA 2592802
(43) Date de publication de la demande: 24.03.2010
(73) Titulaire: Hydro-Québec, Montréal QC H2Z 1A4 (CA)
(72) Inventeur: COUTURE, Pierre, Boucherville, Québec J4B 4A4 (CA)
(74) Mandataire: Cabinet Plasseraud
(86) Numéro de dépôt international: PCT/CA2008/001185
(87) Numéro de publication internationale: WO 2008/154749

(56) Documents cités:
- WO-A1-2005/119875
- JP-A- 10 300 808
- JP-A- H10 300 808
- US-A- 4 766 549
- US-A- 4 766 549
- US-A- 5 070 537
- US-A- 5 070 537
- US-A- 5 682 100
- US-A1- 2003 006 652
- US-A1- 2004 189 317
- AGREZ D: "Cable-fault location using regression functions applied to a reflectogram", MEASUREMENT, INSTITUTE OF MEASUREMENT AND CONTROL. LONDON, GB, vol. 30, no. 2, 1 septembre 2001 (2001-09-01), pages 85-93, XP004248722, ISSN: 0263-2241, DOI: 10.1016/S0263-2241(00)00045-2
- BO Z Q ET AL: "Application of GPS based fault location scheme for distribution system", POWER SYSTEM TECHNOLOGY, 1998. PROCEEDINGS. POWERCON '98. 1998 INTERNA TIONAL CONFERENCE ON BEIJING, CHINA 18-21 AUG. 1998, NEW YORK, NY, USA,IEEE, US, vol. 1, 18 août 1998 (1998-08-18), pages 53-57, XP010312527, DOI: 10.1109/ICPST.1998.728713 ISBN: 978-0-7803-4754-0

## Description

### DOMAINE DE L'INVENTION

La présente invention concerne un appareil et une méthode de surveillance d'une ligne de phase d'un tronçon d'une ligne de transport d'énergie électrique. La ligne de phase comprend n conducteurs isolés électriquement les uns des autres et court circuités entre eux à deux extrémités du tronçon.

### DESCRIPTION DE L'ART ANTÉRIEUR

Connu dans l'art antérieur, il existe le brevet US 6,396,172 et la demande PCT publiée sous le numéro de publication internationale WO 02/41459. Dans ces documents, un appareil de commutation prévu pour être utilisé avec un tronçon d'une ligne de transport d'énergie électrique ayant plusieurs lignes de phase est décrit. Chacune des lignes de phase a plusieurs conducteurs isolés électriquement les uns des autres et branchés en parallèle. Les conducteurs de chaque ligne de phase sont court-circuités entre eux à deux extrémités du tronçon. L'appareil comprend des paires d'interrupteurs branchés en parallèle, pour ouvrir et fermer de façon sélective les conducteurs de chaque ligne de phase, des moyens de détection pour détecter des conditions d'opérations courantes du tronçon et des moyens de commande pour commander les paires d'interrupteurs selon les conditions d'opérations courantes du tronçon.

La demande de brevet CA 2,569,267 décrit un appareil de commutation pour varier l'impédance d'une ligne de phase d'un tronçon d'une ligne de transport d'énergie électrique, la ligne de phase comprend n conducteurs isolés électriquement les uns des autres et court circuités entre eux à deux extrémités du tronçon. L'appareil comprend au moins un premier interrupteur sous vide branché en série avec au moins un des conducteurs, au moins un premier moteur contrôlable pour ouvrir et fermer de façon sélective le premier interrupteur sous vide, un détecteur pour détecter un paramètre représentatif des conditions d'opération courantes de la ligne de phase et un contrôleur pour commander le premier moteur contrôlable en fonction du paramètre détecté par le détecteur. Cette demande décrit également un module de commutation pour varier l'impédance de deux lignes de phase et de deux tronçons adjacents d'une ligne de transport d'énergie électrique et une méthode pour varier l'impédance d'une ligne de phase d'un tronçon d'une ligne de transport d'énergie électrique.

US 5,682,100 décrit un système et un procédé pour localiser des défauts dans le système de distribution de puissance en utilisant des techniques de temporisation et des transpondeurs pour détecter l'arrivée d'une impulsion de défaut transitoire.

US 2004/0189317 divulgue un procédé pour détecter la vitesse de propagation et la localisation d'un défaut sur une ligne électrique en utilisant un émetteur-récepteur haute fréquence pour commander et détecter des impulsions hautes fréquences produites par les défauts.

Le document AGREZ D « *Cable fault location using regression functions applied to a reflectogram* » XP 4248722 décrit un procédé pour estimer les points représentatifs de l'impulsion réfléchie avec la plus faible sensibilité possible par rapport au bruit et éliminer le retard de mesure dû à l'effet de peau en utilisant une fonction de régression quadratique.

Le document Bo Z Q ET AL « Application of GPS based fault location scheme for distribution system » XP01312527 décrit l'application de techniques de localisation de défauts transitoires dans un système de distribution de puissance en utilisant le système GPS.

JP H10 300 808 décrit un système comprenant un capteur de surtension installé à une extrémité d'une ligne de transmission pour mesurer une surtension.

US 5,070,537 décrit un système pour détecter un point de défaut sur une ligne de transmission de puissance en utilisant un signal de temps très précis transmis par satellite.

US 4,766,549 décrit un système pour détecter des défauts sur une ligne de puissance en prenant des mesures uniquement à une extrémité de la ligne.

Il existe donc un besoin pour une méthode de surveillance d'une ligne de phase d'un tronçon d'une ligne de transport d'énergie électrique permettant une surveillance passive ou une surveillance active de la ligne de phase pour suivre l'évolution de la ligne, détecter des fonctionnement anormaux, des défectuosités ou des bris de la ligne, faire des mesures ou contrôler l'écoulement de la puissance.

### SOMMAIRE DE L'INVENTION

La présente invention a pour objet de fournir un appareil et une méthode répondant aux besoins énumérés plus haut.

La présente concerne une méthode comme énoncé dans la revendication 1 et un appareil comme énoncé dans la revendication 5. Des exemples avantageux sont également décrits dans les revendications dépendantes.. En particulier, la présente invention vise une méthode pour localiser un évènement survenu le long d'une ligne de phase sur un tronçon d'une ligne de transport d'énergie électrique, la ligne de phase comportant n conducteurs isolés électriquement les uns des autres et court-circuités entre eux à deux extrémités du tronçon, la méthode comprenant les étapes de :
a) surveiller un paramètre sur un des n conducteurs de la ligne de phase, à une des extrémités du tronçon sans référence à la masse, ledit paramètre étant représentatif de conditions d'opétrations courantes de la ligne de phase et ayant une vitesse de propagation connue dans le conducteur ;
b) générer un signal de détection de l'événement à l'extrémité du tronçon à chaque fois que le paramètre a une valeur qui passe un seuil, et mémoriser un temps de réception lorsque le signal de détection est généré ;
c) émettre un signal représentatif d'une localisation géographique de l'extrémité du tronçon ; et
d) effectuer une localisation géographique de l'événement le long du tronçon une fois que deux signaux de détection consécutifs sont générés à partir du signal représentatif de la localisation géographique de l'étape c), et des temps de réception associés aux deux signaux de détection consécutifs.

La présente invention vise également un appareil pour localiser un événement survenu le long d'une ligne de phase sur un tronçon d'une ligne de transport d'énergie électrique, la ligne de phase comprenant n conducteurs isolés électriquement les uns des autres et court-circuités entre eux à deux extrémités du tronçon, l'appareil étant localisé à une des extrémités du tronçon et comprenant:
un dispositif de surveillance d'au moins un paramètre sur un des n conducteurs de la ligne de phase sans référence à la masse, ledit au moins un paramètre étant représentatif de conditions d'opérations courantes de la ligne de phase et ayant une vitesse de propagation connue dans le conducteur;
un dispositif configuré pour générer un signal de détection de l'événement à l'extrémité du tronçon à chaque fois que ledit au moins un paramètre a une valeur qui passe un seuil, et mémoriser un temps de réception lorsque le signal de détection est généré ;
un dispositif configuré pour émettre un signal représentatif d'une localisation géographique de ladite extrémité du tronçon; et
un dispositif configuré pour effectuer une localisation géographique de l'événement le long du tronçon une fois que deux signaux de détection consécutifs sont générés à partir du signal représentatif de la localisation géographique, et des temps de réception associés aux deux signaux de détection consécutifs.

Une méthode est également divulguée pour déterminer s'il y a une défectuosité le long d'une ligne de phase sur un tronçon d'une ligne de transport d'énergie électrique et localiser ladite défectuosité s'il y en a une, la ligne de phase comprenant n conducteurs isolés électriquement les uns des autres et court-circuités entre eux à deux extrémités du tronçon, la longueur du tronçon étant connue, la méthode comprenant les étapes de:
a) ouvrir un des n conducteurs à une des extrémités du tronçon pour y injecter une impulsion électrique incidente, et mémoriser un temps d'émission de l'impulsion incidente;
b) détecter une impulsion électrique réfléchie reçue en réponse à l'impulsion incidente sur le conducteur à l'extrémité du tronçon sans référence à la masse, et mémoriser un temps de réception de l'impulsion réfléchie, les impulsions ayant une vitesse de propagation connue dans le conducteur;
c) émettre un signal représentatif d'une localisation géographique de l'extrémité du tronçon; et
d) déterminer s'il y a une défectuosité en fonction des temps d'émission et de réception, de la longueur du tronçon et de la vitesse de propagation, et, s'il y a une défectuosité, effectuer une localisation géographique de ladite défectuosité en fonction du signal représentatif de la localisation géographique de l'étape c), des temps d'émission et de réception, et de la vitesse de propagation.

Un appareil est également divulgué pour déterminer s'il y a une défectuosité le long d'une ligne de phase sur un premier tronçon d'une ligne de transport d'énergie électrique et localiser ladite défectuosité s'il y en a une, la ligne de phase comprenant n conducteurs isolés électriquement les uns des autres et court-circuités entre eux à deux extrémités du premier tronçon, la longueur du tronçon étant connue, l'appareil étant localisé à une première des extrémités du premier tronçon et comprenant:
un interrupteur pour ouvrir un des n conducteurs;
un générateur de signal pour injecter une impulsion électrique incidente dans le conducteur;
un détecteur pour détecter sur le conducteur une impulsion électrique réfléchie en réponse à l'impulsion incidente sans référence à la masse, les impulsions ayant une vitesse de propagation connue dans le conducteur;
une mémoire pour mémoriser des temps d'injection de l'impulsion incidente et de réception de l'impulsion réfléchie;
un émetteur pour émettre un signal représentatif d'une localisation géographique de la première extrémité du premier tronçon; et
un dispositif pour déterminer s'il y a une défectuosité en fonction des temps d'émission et de réception, de la longueur du premier tronçon et de la vitesse de propagation, et, s'il y a une défectuosité, effectuer une localisation géographique de ladite défectuosité en fonction du signal représentatif de la localisation géographique émise par l'émetteur, des temps d'injection et de réception, et de la vitesse de propagation.

L'invention sera mieux comprise à la lecture de la description non limitative qui suit d'un mode de réalisation préférentiel de celle-ci, faite en se référant aux dessins annexés.

### BRÈVE DESCRIPTION DES DESSINS

La figure 1 est une vue schématique d'un tronçon d'une ligne de transport d'énergie électrique comprenant des interrupteurs.
La figure 2 est une vue schématique d'un tronçon d'une ligne de transport d'énergie électrique, comprenant des interrupteurs.
La figure 3 est une vue schématique d'un tronçon d'une ligne de transport d'énergie électrique, comprenant des interrupteurs.
La figure 4 est une vue schématique d'un tronçon d'une ligne de transport d'énergie électrique, comprenant des interrupteurs.
La figure 5 est un schéma bloc d'un appareil selon un mode de réalisation préféré relativement à la figure 2.
La figure 6 est un diagramme de circuits illustrant partiellement l'appareil.
La figure 7 est une vue de côté en perspective d'un appareil selon un mode de réalisation préféré.
La figure 8 est une autre vue de côté en perspective de l'appareil montré à la figure 7.
La figure 9 est une vue de côté en perspective d'éléments montrés aux figures 7 et 8.
La figure 10 est une vue de face de ce qui est montré à la figure 9.
La figure 11 est une vue de côté d'éléments montrés aux figures 7 et 8.
La figure 12 est une vue en coupe le long de la ligne A-A de la figure 11.
La figure 13 est une vue agrandie d'une portion de la figure 12.
La figure 14 est une vue agrandie d'une autre portion de la figure 12.
La figure 15 est une vue de côté d'éléments montrés aux figures 7 et 8.
La figure 16 est une vue en coupe le long de la ligne A-A de la figure 15.
La figure 17 est une vue de face schématique de l'appareil montré aux figures 7 et 8.
La figure 18 est une vue de côté en perspective d'un appareil selon un autre mode de réalisation préféré.
La figure 19 est une vue de côté en perspective d'un appareil selon un autre mode de réalisation préféré.
La figure 20 est une autre vue de côté en perspective d'une partie d'un appareil montré à la figure 19.
La figure 21 est une vue de côté en perspective d'éléments montrés aux figures 19 et 20.
La figure 22 est une vue de côté en perspective d'un appareil selon un autre mode de réalisation préféré.
La figure 23 est une vue de côté en perspective d'éléments montrés à la figure 22.
La figure 24 est une vue de côté en perspective d'un appareil selon un autre mode de réalisation préféré.
La figure 25 est une vue de face en perspective d'éléments montrés à la figure 24.
La figure 26 est une vue de côté en perspective d'éléments montrés à la figure 24.
La figure 27 est une vue de côté d'éléments montrés à la figure 24.
La figure 28 est une vue en coupe le long de la ligne A-A de la figure 27.
La figure 29 est une vue de côté d'éléments montrés à la figure 24.
La figure 30 est une vue de côté d'éléments montrés à la figure 24.
La figure 31 est une vue de face d'éléments montrés à la figure 26.
La figure 32 est une vue de côté en perspective d'un appareil selon un autre mode de réalisation préféré.
La figure 33 est une vue de côté en perspective d'éléments montrés à la figure 32.
La figure 34 est une vue de côté d'éléments montrés à la figure 32.
La figure 35 est une vue en coupe le long de la ligne A-A de la figure 34.
La figure 36 est une vue de côté en perspective d'éléments montrés à la figure 32.
La figure 37 est une vue de côté en perspective d'un palonnier pour conducteurs.
La figure 38 est une vue de côté en perspective d'un autre palonnier pour conducteurs.
La figure 39 est une vue de côté en perspective d'un autre palonnier pour conducteurs.
La figure 40 est une vue de côté en perspective d'un autre palonnier pour conducteurs.
La figure 41 est une vue de face en perspective d'un éclairage de secours monté sur une traverse entre quatre conducteurs d'une ligne de phase.
La figure 42 est une vue de côté en perspective d'une antenne d'un bloc d'alimentation capacitif sans contact, montée sur les conducteurs d'une ligne de phase.
La figure 43 est vue de côté en perspective d'un circuit de protection contre les surtensions en combinaison avec un bloc d'alimentation sans contact.
La figure 44 est une vue de côté en perspective d'un pylône sur lequel est monté un appareil selon une mode de réalisation préféré.
La figure 45 est une vue agrandie de la portion supérieure de la figure 44.
La figure 46 est un schéma bloc d'une unité comportant un contrôleur et une partie du détecteur.
La figure 47 est un schéma électrique d'une partie d'un appareil selon le mode de réalisation préféré.
La figure 48 est une vue schématique d'un tronçon d'une ligne de transport d'énergie électrique, comprenant deux appareils selon un autre de réalisation préféré.
La figure 49 est une vue schématique de deux tronçons d'une ligne de transport d'énergie électrique, comprenant deux appareils selon un autre de réalisation préféré.

### DESCRIPTION DÉTAILLÉE DES DESSINS

La présente invention constitue une amélioration de l'invention décrite dans la demande de brevet CA 2,569,267. Cette amélioration consiste principalement en l'ajout de composantes pour convertir une ligne de transport d'énergie électrique en ligne intelligente, sur laquelle on peut exercer une surveillance passive ou active, tel que décrit dans la description non limitative qui suit.

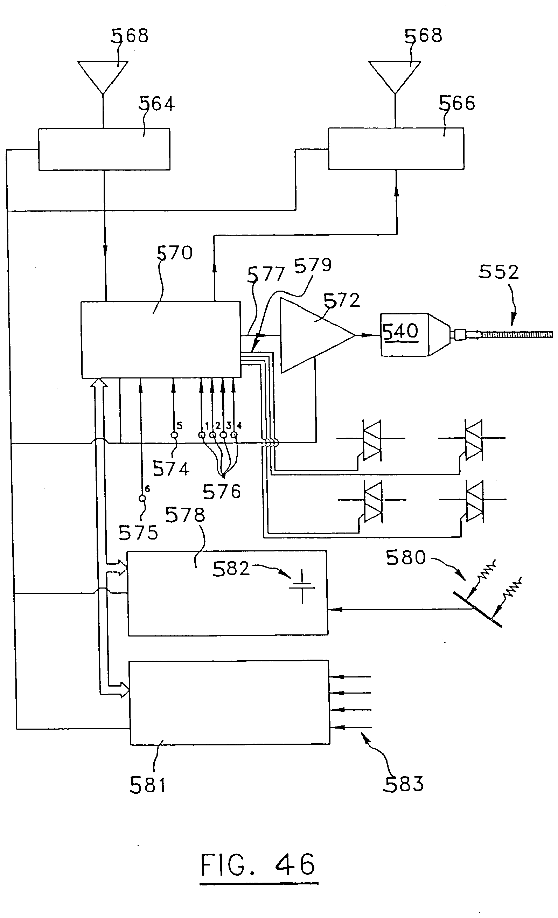

Si on se réfère maintenant aux figures 46, 48 et 49, l'objectif de localiser un événement survenu le long d'une ligne de phase d'un tronçon 1105 d'une ligne de transport d'énergie électrique est atteint avec un appareil 1100. La ligne de phase comprend n conducteurs isolés électriquement les uns des autres et court-circuités entre eux à deux extrémités du tronçon 1105. L'appareil 1100 est localisé à une des extrémités du tronçon 1105.

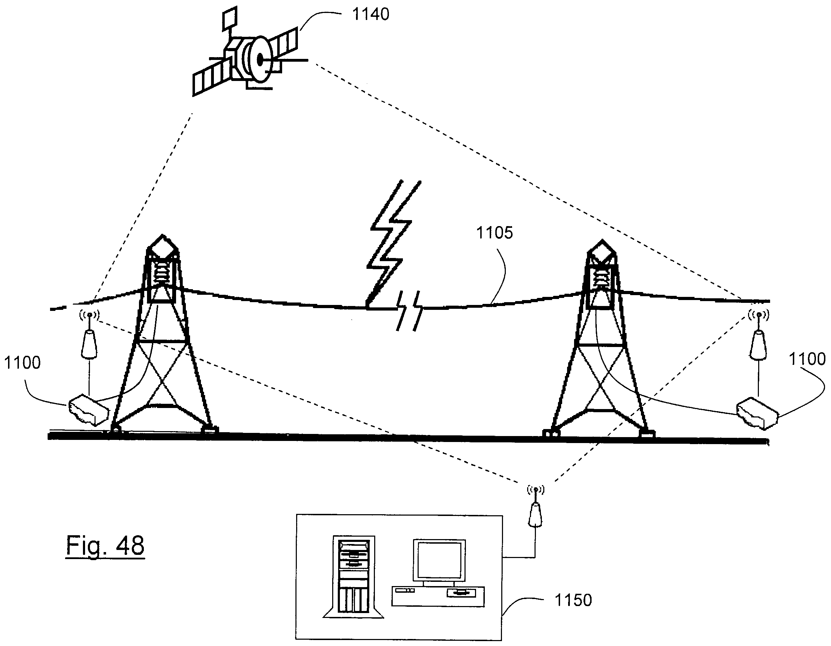

L'appareil 1100 comprend un dispositif de surveillance d'au moins un paramètre sur un des n conducteurs de la ligne de phase. Ledit au moins un paramètre est représentatif de conditions d'opérations courantes de la ligne de phase et a une vitesse de propagation connue dans le conducteur. L'appareil comprend également un dispositif pour générer un signal de détection de l'événement à l'extrémité du tronçon 1105 à chaque fois que ledit au moins un paramètre a une valeur qui passe un seuil, et mémoriser un temps de réception lorsque le signal de détection est généré. L'appareil 1100 comprend aussi un dispositif pour émettre un signal représentatif d'une localisation géographique de ladite extrémité du tronçon 1105. L'appareil 1100 comprend également un dispositif pour effectuer une localisation géographique de l'événement le long du tronçon 1105 une fois que deux signaux de détection consécutifs sont générés à partir du signal représentatif de la localisation géographique, et des temps de réception associés aux deux signaux de détection consécutifs. La longueur du tronçon étant connue, on sait également que lorsque le signal issu de l'événement atteint l'extrémité éloignée du tronçon, il rencontre le court-circuit des conducteurs et produit un signal réfléchi qui revient vers l'appareil. L'appareil reçoit donc un premier signal issu directement de l'événement, et un deuxième signal réfléchi à l'extrémité éloignée du tronçon. Ces deux signaux permettent de localiser l'événement le long du tronçon. Cet appareil surveille de manière dite « passive » la ligne de phase. Dans la figure 48, plusieurs pylônes peuvent être placés entre les pylônes illustrés dans cette figure, d'où la présence de la coupure dans la ligne illustrée dans le schéma. Les dispositifs de surveillance, pour générer le signal de détection de l'événement, pour émettre le signal représentatif de la localisation géographique et pour effectuer la localisation géographique de l'événement le long du tronçon sont réalisés par le processeur 570 qui a des ports d'entrée pour permettre la surveillance d'au moins un paramètre électrique sur un des n conducteurs, et des capacités de calcul pour calculer la localisation géographique de l'événement le long du tronçon. De préférence, le paramètre représentatif de conditions d'opérations courantes est le courant ou la tension.

De préférence, le dispositif de surveillance 1101 est apte à fonctionner à une fréquence d'échantillonnage d'au moins 1 MHz pour surveiller ledit au moins paramètre représentatif de conditions d'opérations. Cette fréquence d'échantillonnage peut monter préférablement jusqu'à 1 GHz. Tel qu'illustré à la figure 48, l'échantillonnage peut être synchronisé en se référant à un système GPS 1140. Le système GPS 1140 peut communiquer avec le processeur 570 pour effectuer une localisation géographique de l'appareil et ainsi diriger les équipes d'entretien vers le tronçon affecté. De plus, l'appareil 1100 peut être commandée numériquement à partir d'un système de contrôle centralisé à distance 1150 qui contrôle et surveille l'ensemble de la ligne de transport en communiquant avec plusieurs appareils.

De préférence, le dispositif de surveillance 1101 comprend des moyens réalisés par le processeur 570, pour enregistrer continuellement des données sur le paramètre dans une fenêtre de temps prédéterminée, et une mémoire pour garder en mémoire seulement les données sur une période de temps commençant 100 µs avant le temps de réception et se terminant lorsque la valeur dudit au moins un paramètre repasse au-dessous du seuil. Ceci permet de mesurer et d'identifier adéquatement un front d'onde qui serait caractéristique de l'événement survenu sur le tronçon.

Selon un mode de réalisation préféré, il est possible de reconstituer le front d'onde à l'origine à partir du front d'onde à l'arrivée de l'appareil, par traitement du signal, et à partir d'une connaissance des caractéristiques de la ligne. De plus, l'appareil peut également être utilisé pour détecter des événements sur des fils de garde associés au tronçon. En effet, les fils de garde sont couplés de façon capacitive et par induction à la ligne de transport. Par conséquent, une perturbation sur le fil de garde a un impact sur les conducteurs, ce qui peut être détecté par l'appareil.

L'appareil peut également utiliser la technologie des phaseurs afin de mieux identifier l'événement ayant survenu sur la ligne. La mesure des phaseurs peut également fournir beaucoup d'information sur la localisation de la défectuosité sur la ligne, et même dans certains cas, permettre d'identifier ce qui aurait pu frapper la ligne. De préférence, la ligne de phase comprend 4 conducteurs.

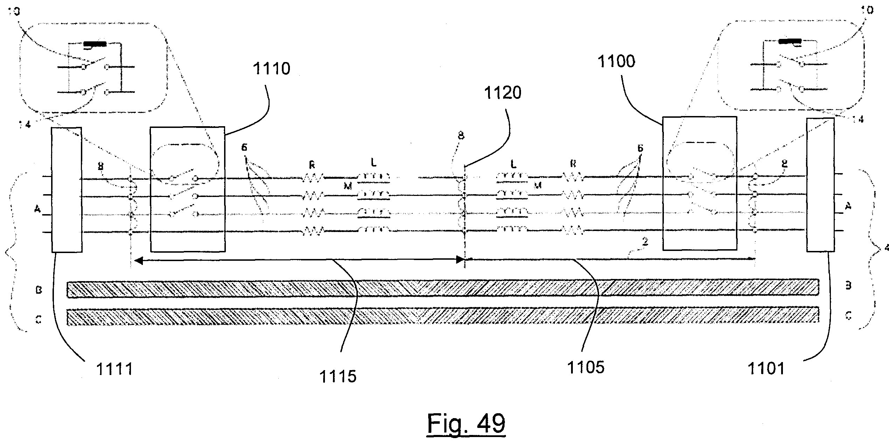

De préférence et tel qu'illustré à la figure 49, un système comprenant deux appareils 1100 et 1110 est divulgué, chaque appareil étant tel que décrit ci-haut. L'appareil 1100 est localisé sur un premier tronçon 1005. Le deuxième appareil 1110 est localisé sur un deuxième tronçon 1115 adjacent au premier tronçon 1105. La figure 49 montre comment les appareils peuvent être montés selon configuration dite « dos-à-dos ». Dans une telle configuration, les paires de tronçons 1105 et 1115 sont adjacents. L'appareil 1100 peut être monté dos-à-dos avec l'appareil 1101 sur un même pylône, et l'appareil 1110 peut aussi être monté dos-à-dos avec l'appareil 1111 sur un autre pylône. Cette configuration permet d'espacer les extrémités de tronçons nécessitant la présence d'appareils. Dans la figure 49, l'extrémité 1120 au centre des deux tronçons 1105 et 1115 n'a pas d'appareil de surveillance ce qui peut être avantageux afin de réduire le nombre d'appareils à surveiller pour l'entretien de la ligne de transport. Dans une telle configuration, étant donné la configuration et les connections entre les différents modules et tronçons, un même événement pourra être détecté par plusieurs modules sur plusieurs tronçons, car un signal caractéristique d'un événement pourrait se propager au-delà d'un seul appareil.

Selon un mode de réalisation préféré, les appareils sur les tronçons sont compatibles avec plusieurs autres capteurs situés sur la ligne. Les appareils peuvent donc servir de relais pour les signaux de ces capteurs afin d'en assurer une bonne qualité de transmission de ces signaux à des systèmes de surveillance appropriés.

L'objectif de localiser un événement survenu le long d'une ligne de phase d'un tronçon 1105 d'une ligne de transport d'énergie électrique est également atteint avec une méthode comprenant plusieurs étapes. La ligne de phase comprend n conducteurs isolés électriquement les uns des autres et court-circuités entre eux à deux extrémités du tronçon. La méthode comprend les étapes de
a) surveiller un paramètre sur un des n conducteurs de la ligne de phase, à une des extrémités du tronçon, ledit paramètre étant représentatif de conditions d'opérations courantes de la ligne de phase et ayant une vitesse de propagation connue dans le conducteur;
b) générer un signal de détection de l'événement à l'extrémité du tronçon à chaque fois que le paramètre a une valeur qui passe un seuil, et mémoriser un temps de réception lorsque le signal de détection est généré ;
c) émettre un signal représentatif d'une localisation géographique de l'extrémité du tronçon; et
d) effectuer une localisation géographique de l'événement le long du tronçon une fois que deux signaux de détection consécutifs sont générés à partir du signal représentatif de la localisation géographique de l'étape c), et des temps de réception associés aux deux signaux de détection consécutifs.

De préférence, l'étape de surveiller un paramètre sur un des n conducteurs de la ligne de phase est effectuée à une fréquence d'échantillonnage d'au moins 1 MHz.

De préférence, dans l'étape a), des données sur le paramètre sont continuellement enregistrées dans une fenêtre de temps prédéterminée, et dans l'étape b), après la génération du signal de détection, les données produites à l'étape a) sont gardées en mémoire seulement sur une période de temps commençant 100 µs avant le temps de réception, et se terminant lorsque la valeur du paramètre repasse au-dessous du seuil. Tel que mentionné précédemment, ceci permet de mesurer et d'identifier adéquatement un front d'onde qui serait caractéristique de l'événement survenu sur le tronçon.

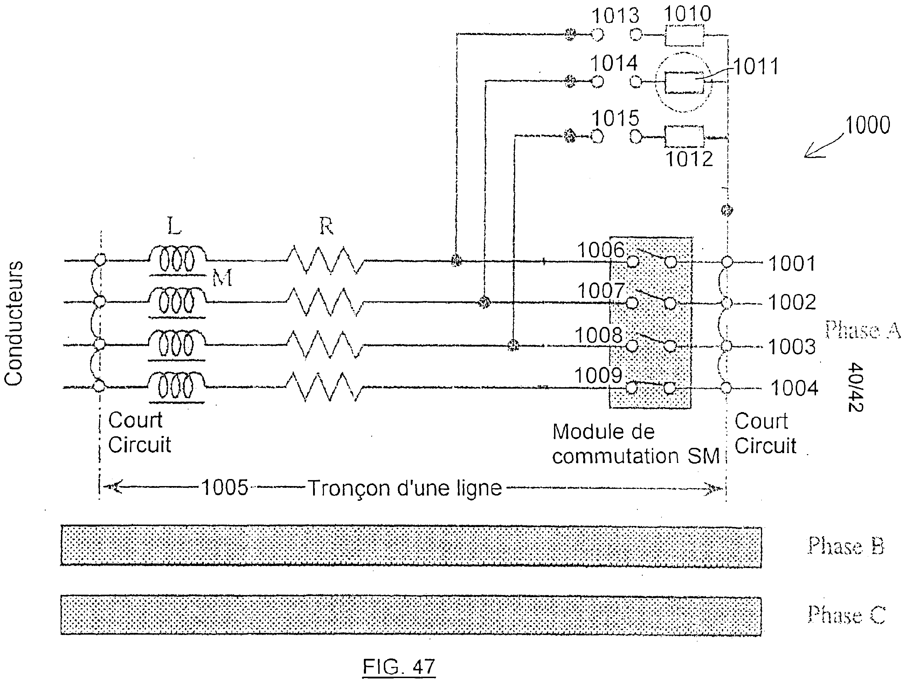

Tel qu'illustré à la Figure 47, l'objectif de surveiller s'il y a une défectuosité le long d'une ligne de phase sur un premier tronçon d'une ligne de transport d'énergie électrique et localiser ladite défectuosité s'il y en a une peut également être atteint avec un appareil 1000 selon un autre mode de réalisation préféré. La ligne de phase comprend n conducteurs 1001, 1002, 1003 et 1004 isolés électriquement les uns des autres et court-circuités entre eux à deux extrémités du premier tronçon. La longueur du tronçon est connue. L'appareil 1000 est localisé à une première des extrémités du premier tronçon. L'appareil 1000 comprend un interrupteur 1006, 1007, 1008 ou 1009 pour ouvrir un des n conducteurs. L'appareil 1000 comprend aussi un générateur de signal 1010, 1011 et 1012 pour injecter une impulsion électrique incidente dans le conducteur. L'appareil 1000 comprend également un détecteur pour détecter sur le conducteur une impulsion électrique réfléchie en réponse à l'impulsion incidente, les impulsions ayant une vitesse de propagation connue dans le conducteur. L'appareil 1000 comprend aussi une mémoire pour mémoriser des temps d'injection de l'impulsion incidente et de réception de l'impulsion réfléchie. L'appareil 1000 comprend également un émetteur pour émettre un signal représentatif d'une localisation géographique de la première extrémité du premier tronçon. L'appareil 1000 comprend aussi un dispositif pour déterminer s'il y a une défectuosité en fonction des temps d'émission et de réception, de la longueur du premier tronçon et de la vitesse de propagation, et, s'il y a une défectuosité, effectuer une localisation géographique de ladite défectuosité en fonction du signal représentatif de la localisation géographique émise par l'émetteur, des temps d'injection et de réception, et de la vitesse de propagation. Les différents dispositifs de l'appareil 1000 peuvent être réalisés par un processeur 570 tel que montré par exemple à la figure 46. Cet appareil surveille de manière dite « active » la ligne de phase.

De préférence, le détecteur est apte à fonctionner à une fréquence d'échantillonnage d'au moins 1 MHz pour détecter ladite impulsion réfléchie.

De préférence, l'appareil comprend un processeur, par exemple le processeur 570 montré à la figure 46, qui permet de réaliser des moyens pour détecter et enregistrer des données sur le conducteur à partir du moment où l'impulsion électrique incidente est injectée jusqu'au moment où l'impulsion électrique réfléchie est détectée.

L'objectif de déterminer s'il y a une défectuosité le long d'une ligne de phase sur un tronçon d'une ligne de transport d'énergie électrique et localiser ladite défectuosité s'il y en a une, peut aussi être atteint avec une méthode comprenant plusieurs étapes selon un autre mode de réalisation. La ligne de phase comprend n conducteurs isolés électriquement les uns des autres et court-circuités entre eux à deux extrémités du tronçon. La longueur du tronçon est connue. La méthode comprend les étapes de:
a) ouvrir un des n conducteurs à une des extrémités du tronçon pour y injecter une impulsion électrique incidente, et mémoriser un temps d'émission de l'impulsion incidente;
b) détecter une impulsion électrique réfléchie reçue en réponse à l'impulsion incidente sur le conducteur à l'extrémité du tronçon, et mémoriser un temps de réception de l'impulsion réfléchie, les impulsions ayant une vitesse de propagation connue dans le conducteur;
c) émettre un signal représentatif d'une localisation géographique de l'extrémité du tronçon; et
d) déterminer s'il y a une défectuosité en fonction des temps d'émission et de réception, de la longueur du tronçon et de la vitesse de propagation, et, s'il y a une défectuosité, effectuer une localisation géographique de ladite défectuosité en fonction du signal représentatif de la localisation géographique de l'étape c), des temps d'émission et de réception, et de la vitesse de propagation.

De préférence, l'étape de détecter l'impulsion réfléchie sur le conducteur à l'extrémité du tronçon, et mémoriser le temps de réception de l'impulsion réfléchie est effectuée à une fréquence d'échantillonnage d'au moins 1 MHz.

De préférence, l'étape b) comprend une étape de détecter et enregistrer des données sur le conducteur à partir du moment où l'impulsion électrique incidente est injectée jusqu'au moment où l'impulsion électrique réfléchie est détectée.

Selon un autre mode de réalisation préféré, l'objectif de surveiller une ligne de phase d'un tronçon d'une ligne de transport d'énergie électrique peut également être atteint avec un appareil de surveillance 1000, tel qu'illustré plus particulièrement à la figure 47. La ligne de phase comporte n conducteurs 1001, 1002, 1003 et 1004 isolés électriquement les uns des autres et court-circuités entre eux à deux extrémités du tronçon 1005. L'appareil comprend au moins un premier interrupteur 1006, 1007, 1008 et 1009 branché en série avec au moins un des conducteurs 1001, 1002, 1003 et 1004.

L'appareil 1000 comprend également, tel que montré par exemple à la figure 46, un détecteur pour détecter au moins un paramètre représentatif des conditions d'opération courantes de la ligne de phase. L'appareil comprend un processeur ayant des premiers ports d'entrée pour recevoir des signaux indicatifs des positions d'opération des interrupteurs et au moins un second port d'entrée pour recevoir des signaux indicatifs du paramètre. L'appareil comprend également un récepteur radiofréquence branché au processeur pour recevoir des signaux de commande et un contrôleur pour commander le premier interrupteur 1006, 1007, 1008 et 1009 en fonction des signaux de commande. L'appareil comprend aussi un émetteur radiofréquence branché à au processeur pour émettre des signaux indicatifs des positions d'opération des interrupteurs 1006, 1007, 1008 et 1009 et du paramètre. L'appareil comprend de également des moyens d'alimentation électrique pour alimenter le processeur, le récepteur et l'émetteur.

De préférence, l'appareil de surveillance 1000 d'une ligne de phase d'un tronçon d'une ligne de transport d'énergie électrique comprend également un générateur d'impulsions haute tension 1010, 1011 et 1012 et un éclateur 1013, 1014 et 1015 branché en série avec le générateur d'impulsions 1010, 1011 et 1012. Le générateur d'impulsion et l'éclateur forment un circuit branché en parallèle avec le premier interrupteur. Dans un autre mode de réalisation, le générateur d'impulsions est un générateur d'impulsions de courant.

L'objectif de surveiller une ligne de phase d'un tronçon d'une ligne de transport d'énergie électrique est également atteint avec une méthode pour surveiller une ligne de phase d'un tronçon d'une ligne de transport d'énergie électrique. La ligne de phase comporte n conducteurs 1001, 1002, 1003 et 1004 isolés électriquement les uns des autres et court-circuités entre eux à deux extrémités du tronçon 1005. La méthode comprend les étapes de fournir au moins un premier interrupteur 1006, 1007, 1008 et 1009 branché en série avec au moins un des conducteurs 1001, 1002, 1003 et 1004, détecter au moins un paramètre représentatif des conditions d'opérations courantes de la ligne de phase, recevoir des signaux indicatifs des positions d'opération des interrupteurs 1006, 1007, 1008 et 1009 et des signaux indicatifs du paramètre avec un processeur ayant des premiers ports d'entrée et au moins un second port d'entrée. La méthode comprend également recevoir des signaux de commande avec un récepteur radiofréquence branché au processeur, commander le premier interrupteur 1006, 1007, 1008 et 1009 en fonction du des signaux de commande, émettre des signaux indicatifs des positions d'opération des interrupteurs 1006, 1007, 1008 et 1009 et du paramètre avec un émetteur radiofréquence branché à au processeur et alimenter le processeur, le récepteur et l'émetteur avec des moyens d'alimentation électrique.

De préférence, la méthode pour surveiller une ligne de phase d'un tronçon d'une ligne de transport d'énergie électrique comprend également, avant l'étape de détecter au moins un paramètre, les étapes de générer une impulsion haute tension avec un générateur d'impulsions haute tension 1010, 1011 et 1012, d'éclater l'impulsion avec un éclateur 1013, 1014 et 1015 pour produire une impulsion haute tension et d'injecter l'impulsion haute tension dans le conducteur 1001, 1002 ou 1003.

### Définition

Une Ligne de Transport Intelligente (LTI) ou "Smart Power Line (SPL)" est composée d'une ligne de Transport en faisceau conventionnel (ex : ligne à 735 KV) sur laquelle on isole les sous-conducteurs des phases sur des segments de 30 Km et à laquelle on ajoute à tous les 60 Km, sur un pylône d'ancrage, des commutateurs embarqués sur les phases et un système de surveillance passif ou actif de la ligne.

### Principe de fonctionnement

Les commutateurs embarqués redirigent le courant dans un ou plusieurs des sous conducteurs du faisceau de manière à déglacer la ligne ou à en moduler l'impédance (Modulateur d'Impédance de Ligne MIL, ou "Line Impedance Modulator LIM"). Une ligne de transport intelligente, en plus de s'auto-analyser et de s'auto-surveiller pour fin d'entretien, permet de suivre en temps réel le comportement électrique de la ligne et du réseau et permet de modifier, au besoin, l'écoulement de la puissance dans la ligne et dans le réseau électrique.

Cette technologie embarquée à haute redondance agit directement sur le réseau et elle peut être commandée numériquement à partir d'un contrôle centralisé à distance. Elle est compatible avec un réseau intelligent.

Cette technologie de « Flexible AC Transmission System » FACTS distribués complète les autres FACTS du réseau.

### Impact sur le fonctionnement d'une ligne de transport conventionnelle

L'ajout de cette technologie sur une ligne de transport conventionnelle ne compromet pas :
- l'isolation électrique de la ligne, puisqu'elle est embarquée directement sur la phase sans aucune référence avec les autres phases ou avec la masse;
- la continuité électrique de la ligne, car en tout temps un lien galvanique direct ou un lien galvanique "make before break " en assure la continuité;
- la capacité de transit maximale de la ligne, car en tout temps des cavaliers de contournements internes permettent de redonner à la ligne sa pleine capacité de transit; et
- la résistance mécanique de la ligne, car elle n'est pas mécaniquement en série avec la ligne. Elle est supportée par les cavaliers de contournement sur un pylône d'ancrage. Ce pylône d'ancrage et les commutateurs embarqués constituent une mini sous-station.

### Impact sur la fiabilité et la sécurité de la ligne

Cette technologie permet d'accroître la fiabilité électrique de la ligne et du réseau :
- en réduisant le nombre de courts-circuits dus au galop par la détection et la suppression du galop avec le déglaçage sous charge;
- en réduisant le nombre de courts-circuits dus au verglas, au givre ou à la neige fondante avec le déglaçage sous charge; et
- en redirigeant la puissance vers d'autres lignes en cas de contingence.

### Impact sur le fonctionnement de la ligne

Cette technologie permet d'accroître de manière très importante la fiabilité mécanique de la ligne et de prolonger sa durée de vie :
- en évitant l'effondrement de la ligne dû au verglas, au givre ou à la neige fondante avec le déglaçage sous charge;
- en réduisant la fatigue et en évitant les bris dus au galop avec le déglaçage sous charge.
- en évitant le vieillissement accéléré dû à une surcharge provoquée par des événements climatiques exceptionnels, par exemple, une combinaison de vent et de verglas, de vent et de givre ou de vent et de neige fondante; et
- en évitant la rotation des faisceaux provenant d'un délestage aléatoire de la glace. Elle permet de garder en tout temps le centre de masse en bas du centre géométrique du faisceau par un contrôle de la séquence de délestage des sous-conducteurs.

### Impact sur l'entretien de la ligne

Cette technologie de surveillance passive permet un entretien préventif spécifique et localisé de la ligne ou des commutateurs par :
- une localisation précise des fautes à la masse et interphase, par la mesure et l'analyse du temps de vol de l'événement perturbateur, c'est-à-dire le temps nécessaire avant que l'événement ne soit détecté par un ou plusieurs détecteurs;
- une localisation précise des foudres, par la mesure et l'analyse du temps de vol de l'événement perturbateur;
- une localisation précise des bris de lignes, par la mesure et l'analyse du temps de vol de l'événement perturbateur;
- une localisation de l'accroissement d'un effet couronne provenant d'un défaut sur les fils ou les anneaux de garde sur la ligne;
- une comparaison des signatures d'arc des commutateurs à vide;
- un suivi en continu du parcours du courant dans le module de commutation, par la mesure et l'analyse des courants et des tensions.

Cette technologie de surveillance active de la ligne à l'aide d'un générateur d'impulsions à haute tension localisé à l'intérieur du module de commutation permet de :
- surveiller l'état d'isolation des entretoises et des palonniers, par la mesure et l'étude des réflexions produites par les défauts d'isolation; et
- surveiller l'état des conducteurs, par la mesure et l'étude des réflexions produites par les défauts des conducteurs.

### Impact sur la protection de la ligne et du réseau

La mesure du phaseur en plus de permettre de suivre le comportement de la ligne et du réseau, permet d'accroître la protection de la ligne, par une action directe sur les disjoncteurs.

La mesure des phaseurs permet aussi de vérifier le fonctionnement et la calibration des équipements de mesure dans les sous-stations du réseau.

La mesure des phaseurs permet également de visualiser l'écoulement de puissance dans le réseau.

### Impact sur le fonctionnement du réseau

Cette technologie modulaire et distribuée permet d'accroître la capacité de transit du réseau :
- en contrôlant l'écoulement de puissance, par la modulation de l'impédance des lignes de manière à réduire les goulots d'étranglement.

Et dans des versions plus avancées :
- en stabilisant les oscillations interrégionales, par l'ajout d'amortissement; et
- en augmentant la stabilité du réseau, par l'ajout de résistances de freinage distribuées.

### Augmentation de la capacité de transit d'une ligne

On peut accroître la capacité de transit d'une ligne mono conducteur ou bi conducteurs et la rendre intelligente en ajoutant d'autres conducteurs par phases et en ajoutant des modules de commutation de manière à pouvoir la déglacer et à pouvoir en contrôler l'écoulement de puissance.

Le poids additionnel des conducteurs est compensé par la réduction de la charge de glace due à l'ajout des modules de déglaçage. Cette méthode permet d'éviter d'avoir à renforcer les tours, les isolateurs et les fondations de la ligne.

Cette modification, en plus d'accroître la capacité de transit d'une ligne, réduit le rayonnement couronne.

De façon générale on peut dire que la conversion d'une ligne conventionnelle en ligne intelligente permet de suivre l'évolution de la ligne, de réduire le galop, d'éviter l'effondrement de la ligne dû au verglas, au givre ou à la neige fondante, de réduire le nombre de fautes dues au galop, au verglas, au givre ou à la neige fondante et par voie de conséquence d'augmenter la durée de vie de la ligne. De plus, une ligne intelligente peut servir d'instrument de mesure à un réseau intelligent et d'actuateur pour contrôler l'écoulement de puissance de ce même réseau. Tous ces avantages sont obtenus sans compromette le fonctionnement de cette dernière.

La description qui suit reprend en partie la description décrite dans la demande de brevet CA 2,569,267.

Dans les dessins, les câbles reliant les différents éléments de l'appareil de commutation, les capteurs et les cartes de commande des interrupteurs électroniques ne sont pas montrés.

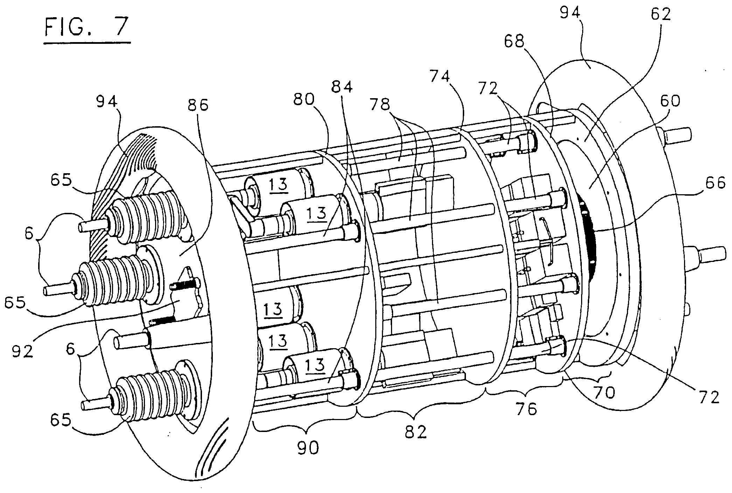

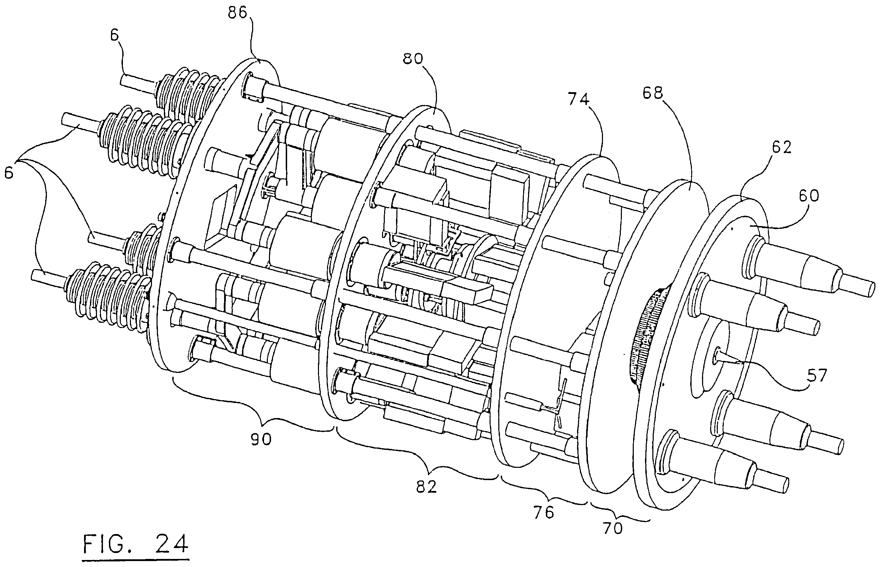

Un modulateur d'impédance de ligne (LIM) est divulgué qui est un système de transmission AC distribué flexible (FACTS) où chacun des tronçons a une longueur de plusieurs dizaines de kilomètres et est indépendant. Chaque tronçon de la ligne de transport d'énergie électrique comprend un module de commutation dans lequel au moins un interrupteur sous vide branché en série avec au moins un des conducteurs du tronçon. Selon un mode de réalisation préféré tel que montré à la figure 7, au moins un des conducteurs ne comprend pas d'interrupteur ce qui veut dire qu'un tel conducteur fourni constamment un lien galvanique. Selon d'autres modes de réalisation préférés de la présente invention, où des interrupteurs sont pourvus sur tous les conducteurs, tel que montré par exemple à la figure 24, un dispositif de fermeture avant rupture est pourvu de façon à ce que les quatre connecteurs d'un tronçon d'une ligne de phase ne soient jamais ouverts simultanément.

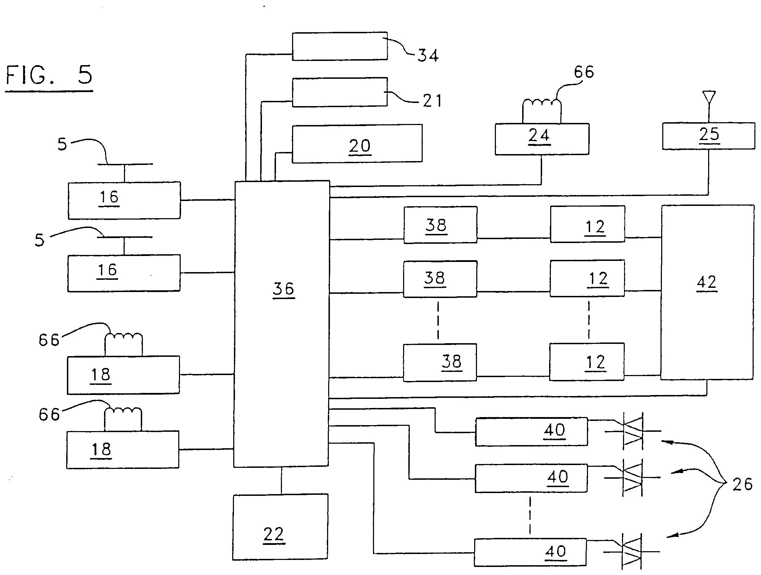

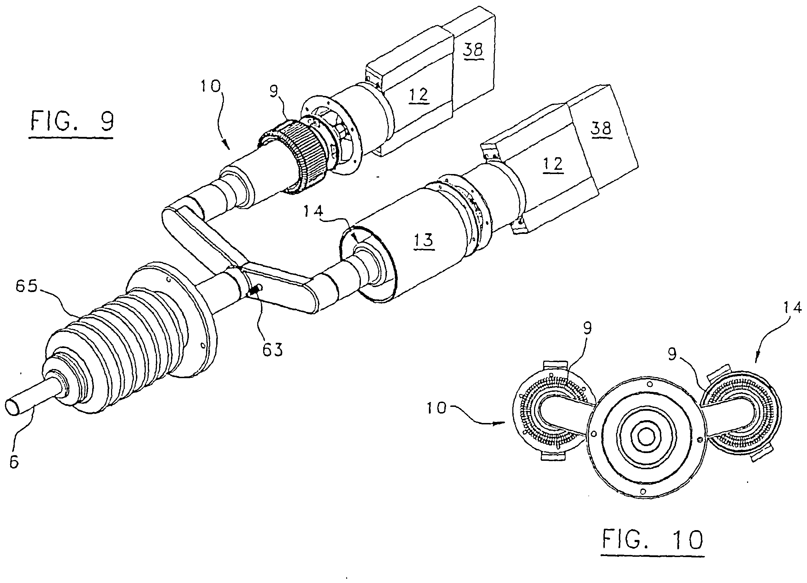

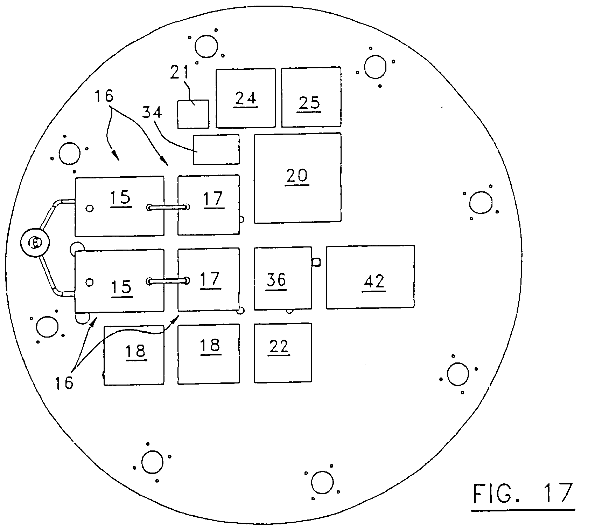

De la redondance est prévue à plusieurs niveaux pour des raisons de sécurité. Par exemple, selon des modes de réalisation préférés, des paires d'interrupteurs sous vide tels que montrés aux figures 9 à 14, branchés en parallèle sont prévus. Toujours selon des modes de réalisation préférés, des vérins linéaires tels que montrés aux figures 9 à 14, sont prévus pour forcer la fermeture ou l'ouverture d'un interrupteur sous vide donné dans le cas d'un fonctionnement défectueux. Toujours selon un mode de réalisation préféré, tel que montré aux figures 5 et 17, des communications sont prévues au moyen de communications de ligne par transport d'énergie électrique, de communications sans fil ou encore de communications par fibres optiques. Une commande à distance de l'appareil peut être effectuée via le système de communication. Toujours selon des modes de réalisation préférés, tel que montré aux figures 7, 17 et 42, un bloc d'alimentation est fourni à partir de la ligne de transport d'énergie électrique au moyen d'un bloc d'alimentation sans contact fonctionnant soit avec des coupleurs magnétiques ou des coupleurs capacitifs.

Toujours selon des modes de réalisation préférés, des données représentatives d'événements courants et passés de la ligne de transport peuvent être fournies pour analyse. Toujours selon un mode de réalisation préféré, une boîte noire contenant une mémoire emmagasinant des données représentatives d'événements courants et passés de l'appareil est prévue, telle que montrée à la figure 5 ou à la figure 46.

Toujours selon un mode de réalisation préféré, des moyens sont prévus pour fermer tous les conducteurs des lignes de phase de la ligne de transport d'énergie électrique en cas d'un fonctionnement défectueux du système de communication pour ainsi rétablir la ligne de phase. Toujours selon un mode de réalisation préféré, des données représentatives des opérations courantes de chaque ligne de phase du tronçon peuvent être envoyées à travers un système de communication pour un diagnostic à distance et pour entretien.

Selon un mode de réalisation préféré, en cas d'une perte de communication avec un ou plusieurs appareils de commutation, les interrupteurs sous vide dans un ou plusieurs appareils se ferment eux-mêmes dans une séquence préétablie provoquant un retour de la ligne de transmission à son état initial à l'intérieur de quelques dizaines de millisecondes, ce qui signifie que la ligne de transport d'énergie électrique récupère sa pleine capacité de transport. Par ailleurs, en cas de perte d'un bloc d'alimentation dans un des appareils de commutation, les interrupteurs sous vide se ferment eux-mêmes dans une séquence préétablie et la ligne revient à son état initial à l'intérieur de quelques dizaines de millisecondes ce qui signifie que le tronçon de la ligne de transport d'énergie électrique retrouve sa pleine capacité.

Des applications potentielles incluent entre autres: un modulateur d'impédance de ligne (LIM); un déglaceur de ligne; un bloc d'alimentation en ligne; un limiteur de courant; un amortisseur de résonance sous synchronisme; un amortisseur d'oscillation inter régions; et une résistance de freinage. Des composantes passives peuvent être ajoutées à l'appareil selon l'enseignement de la demande PCT publiée sous le numéro de publication internationale 02/41459, publiée le 23 mai 2002.

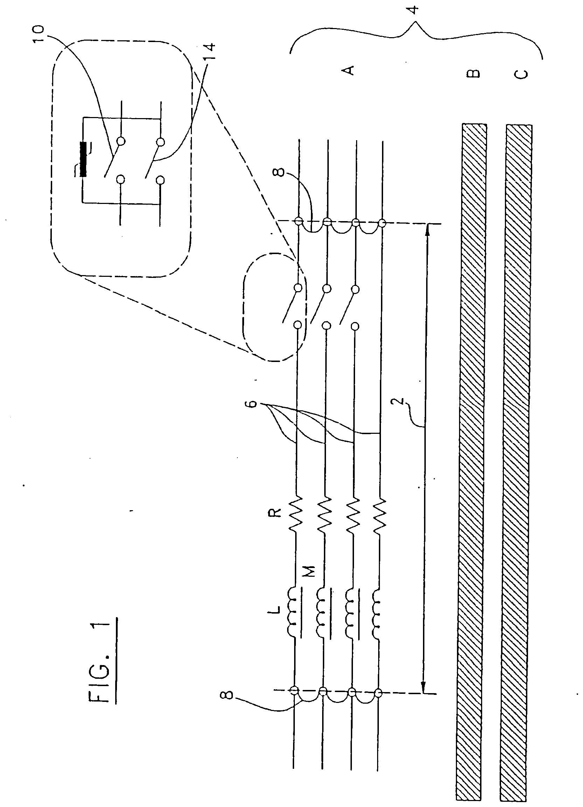

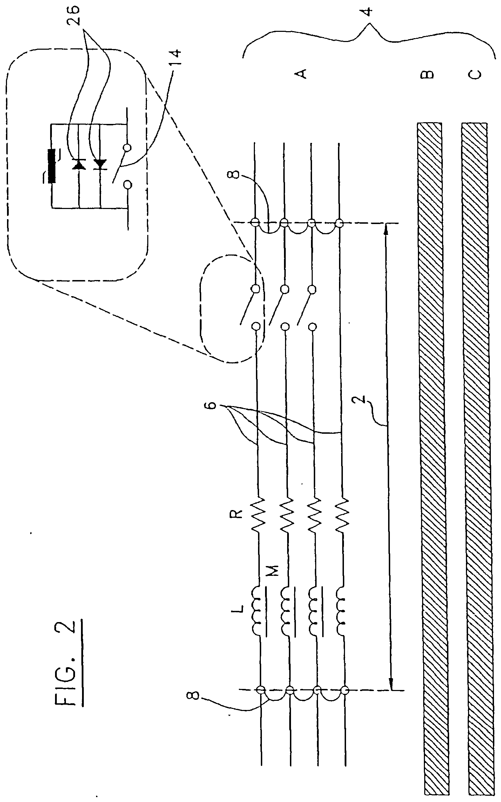

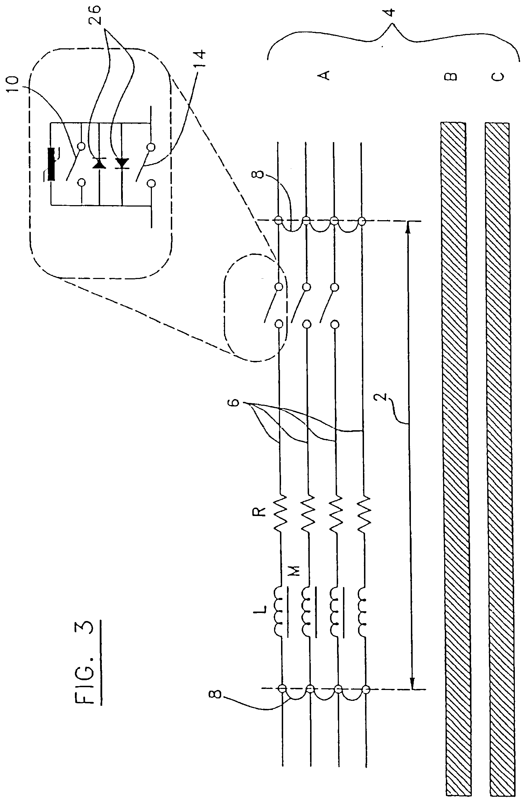

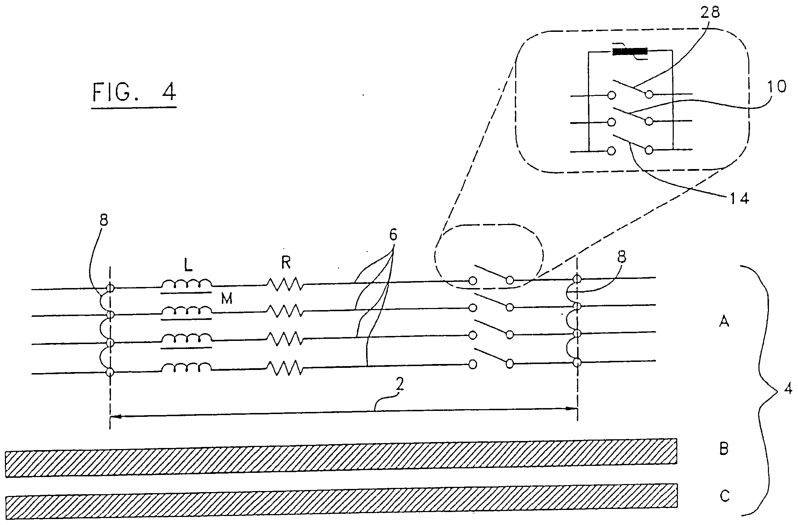

Nous nous référerons maintenant aux figures 1 à 5. Les composantes montrées à la figure 5 sont spécifiquement adaptées au mode de réalisation montré à la figure 2 mais peuvent être facilement adaptées au mode de réalisation de la figure 1 et même aux modes de réalisation montrés aux figures 3 et 4, par un expert dans le domaine. Un appareil de commutation pour varier l'impédance d'une ligne de phase d'un tronçon 2 d'une ligne de transport d'énergie électrique 4 est montré. La ligne de phase inclut quatre conducteurs 6 électriquement isolés les uns des autres et court-circuités entre eux à deux extrémités du tronçon au moyen de court circuits 8. La ligne de phase montre quatre conducteurs mais il peut y avoir n conducteurs 6. R, L, M représentent respectivement la résistance, l'inductance et l'inductance mutuelle du tronçon 2 de la ligne de phase 4. Le tronçon 2 a trois lignes de phase A, B et C.

Au minimum, l'appareil comprend au moins un interrupteur sous vide branché en série avec au moins un des conducteurs 6. Dans le cas présent, il y a trois interrupteurs sous vide 10 associés respectivement à trois conducteurs de la ligne de phase, trois premiers moteurs contrôlables 12 pour ouvrir et fermer de façon sélective les trois premiers interrupteurs sous vide 10, les trois seconds interrupteurs sous vide 14 branchés en parallèle respectivement avec les premiers interrupteurs sous vide 10, et trois seconds moteurs contrôlables 12 pour ouvrir et fermer de façon sélective les deuxièmes interrupteurs sous vide 14. L'appareil comprend également un détecteur pour détecter un paramètre représentatif des conditions d'opérations courantes de la ligne de phase 4. Dans le cas présent, des blocs d'alimentation sans contact capacitifs et inductifs 16 et 18 sont fournis. L'appareil comprend aussi un contrôleur 20 pour commander les premiers et deuxièmes moteurs contrôlables 12 selon des paramètres détectés par les détecteurs et des requêtes d'une commande à distance. Un bloc d'alimentation principal sans contact est prévu pour alimenter une alimentation électrique à partir de la ligne de phase. Le bloc d'alimentation principal sans contact comprend les blocs d'alimentation capacitifs et inductifs 16 et 18.

Des convertisseurs sont prévus pour convertir l'alimentation électrique à partir de la ligne de phase en alimentation CC et CA. L'alimentation CC alimente une boîte de condensateur 22 pour emmagasiner l'énergie CC.

Chacun de blocs d'alimentation 16 et 18 est doublé pour assurer une redondance. Chaque bloc d'alimentation inductif 18 comprend des transformateurs de courant 66 situés dans un compartiment de l'appareil tel que montré par exemple à la figure 7. Ces transformateurs ont leur primaire alimenté par le courant de phase. Le secondaire de ces transformateurs alimente un convertisseur qui est branché à des condensateurs de stockage situés dans la boîte de condensateur 22 via une boîte de distribution 36.

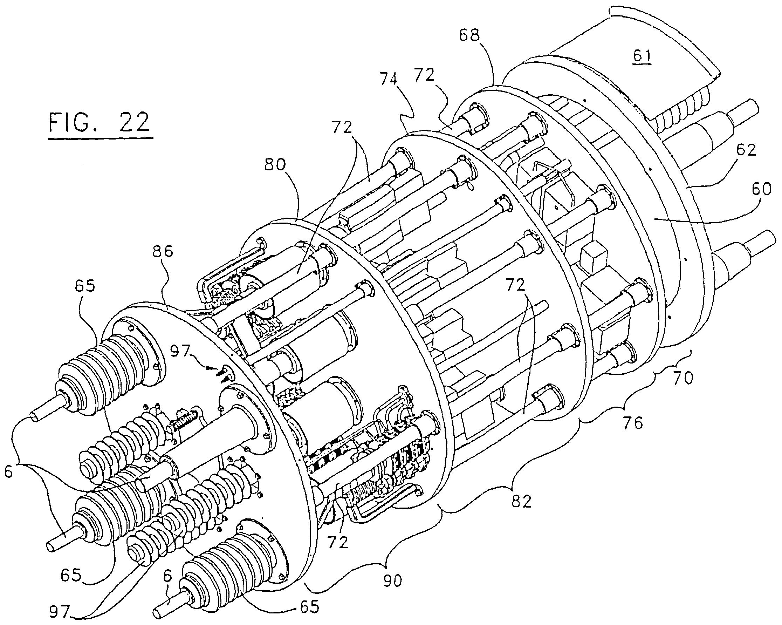

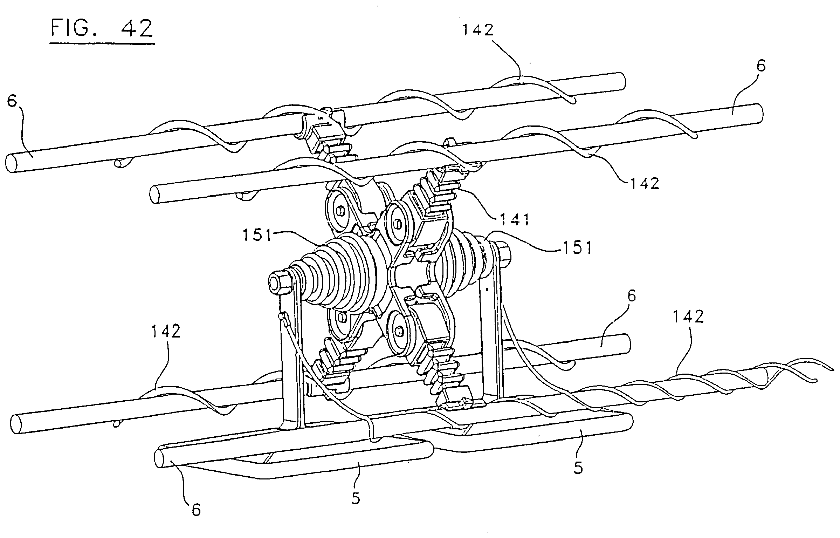

Chacun des blocs d'alimentation capacitifs 16 comprend une plaque conductrice isolée appelée antenne capacitive 5, montrée par exemple à la figure 42, située à quelques centimètres des conducteurs de la ligne de phase. L'antenne 5 est branchée électriquement au transformateur 15 montré à la figure 17 et située à l'intérieur de l'appareil de commutation à l'aide d'une traversée d'isolateur 97 montré par exemple à la figure 22. Les transformateurs 15 alimentent les convertisseurs 17 montrés à la figure 17, branchés à la boîte de condensateur 22 via la boîte de distribution 36.

Ces blocs d'alimentation capacitifs et inductifs 16 et 18 sont branchés à la boîte de distribution 36 qui distribue l'énergie électrique à différents éléments de l'appareil. La boîte de distribution 36 est contrôlée par le contrôleur 20 de l'appareil de commutation.

Le système de communication de ligne de transport 24 de type PLC (ligne de transport d'énergie électrique) est branché au contrôleur 20 pour communication par la ligne de phase, et un routeur émetteur/récepteur 25 est branché au PLC et au contrôleur 20 pour communication sans fil. Un système de positionnement mondial 21 est aussi prévu pour localiser l'appareil de commutation par satellite et pour des fins de minutage. Le routeur 25 et le système de positionnement mondial 21 ont une antenne 57 telle que montrée par exemple à la figure 24.

Tous les appareils de commutation d'une ligne de transport d'énergie électrique peuvent être liés à un réseau de télécommunication local. Dans ce réseau local, l'appareil de commutation de chacune des lignes de phase communique: 1) entre les différents tronçons de la ligne de transport d'énergie électrique à travers le PLC; 2) entre les appareils de commutation d'un tronçon à travers un lien radiofréquence courte portée ou infrarouge; et 3) au poste répéteur aux deux extrémités de la ligne de transport d'énergie électrique ou entre les deux, à travers un lien radiofréquence courte portée, un lien infrarouge ou un lien par fibres optiques.

Si on se réfère maintenant à la figure 2, on peut voir un mode de réalisation où l'appareil comprend trois interrupteurs électroniques 26 branchés en parallèle respectivement avec les trois interrupteurs sous vide 14, les interrupteurs électroniques 26 sont contrôlés par le contrôleur. Il va de soi, que l'appareil peut contenir moins de trois interrupteurs électroniques.

Si on se réfère maintenant à la figure 3, l'appareil, dans ce mode de réalisation, comprend trois interrupteurs électroniques 26 branchés en parallèle aux premiers et deuxièmes interrupteurs sous vide 10 et 14. Il est aussi possible de prévoir moins de trois interrupteurs électroniques.

Si on se réfère à la figure 4, on peut voir un appareil pour le déglaçage. Cet appareil comprend quatre premiers, deuxièmes et troisièmes interrupteurs sous vide 10, 14 et 28 branchés en parallèle et associés respectivement à quatre conducteurs de la ligne de phase, et quatre premiers, deuxièmes et troisièmes moteurs contrôlables 12 pour ouvrir et fermer de façon sélective les premiers, deuxièmes et troisièmes interrupteurs sous vide 10, 14 et 28.

Si on se réfère maintenant à la figure 5, l'appareil comprend une boîte noire 34 comprenant une mémoire et un boîtier pour protéger la mémoire. La mémoire est branchée au contrôleur 20 pour enregistrer des paramètres représentatifs d'événements courants et passés de l'appareil de commutation et de la ligne de phase. Le contrôleur 20 permet également d'effectuer des calculs à partir des données mesurées. Les moteurs contrôlables 12 peuvent être des moteurs linéaires monophasés, des moteurs linéaires polyphasés, des moteurs réguliers comprenant une vis mère ou tout autre type de moteur. Le flux de signaux et d'alimentations électrique à l'intérieur de l'appareil est effectué au moyen de la boîte de distribution 36. Chaque moteur 12 est branché à la boîte de distribution via un convertisseur de moteur 38. Chaque interrupteur électronique 26 est branché à la boîte de distribution via une carte de contrôle a interrupteur électronique 40.

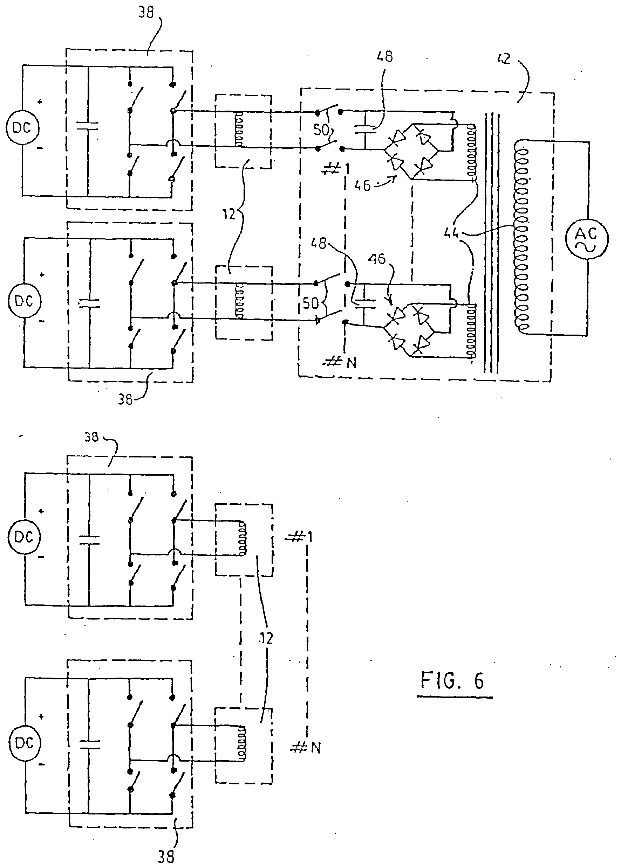

Nous référerons maintenant aux figures 5 et 6. Les moteurs 12 montrés dans la partie supérieure de la figure 6, sont pour commander les deuxièmes interrupteurs sous vide 14 montrés par exemple à la figure 1. Les moteurs 12 montrés dans la partie inférieure des figures sont pour commander les premiers interrupteurs sous vide 10 aussi montrés, par exemple, à la figure 1. Comme on peut le voir à la figure 6, les moteurs pour contrôler les deuxièmes interrupteurs sous vide 14 qui sont utilisés comme shunt sont branchés à un dispositif "déclencheur associé" 42. Ce dispositif "déclencheur associé" 42 comprend, pour chacun des deuxièmes moteurs contrôlables, un bloc d'alimentation dédié sans contact 44 pour alimenter une alimentation électrique à partir de la ligne de phase, un redresseur 46 pour redresser l'alimentation électrique, un condensateur 48 pour accumuler de l'énergie électrique à partir de la sortie du redresseur 46 et un interrupteur contrôlable 50 pour décharger le condensateur 48 dans le deuxième moteur contrôlable correspondant pour fermer celui-ci, sur réception d'un signal de commande du contrôleur 20. Le contrôleur 20 a un détecteur pour détecter un fonctionnement défectueux du routeur émetteur/récepteur haute fréquence 25 et du système de communication de ligne de transport d'énergie électrique 24 et tout autre fonctionnement défectueux, et un générateur de commande pour générer le signal de commande à partir d'une détection du fonctionnement défectueux pour fermer au moins un ou tous les deuxièmes interrupteurs sous vide 14 montrés par exemple à la figure 1 à travers le convertisseur de moteur 38 s'il n'y a pas de réponse à travers le dispositif "déclencheur associé" 42.

Le contrôleur a aussi un détecteur pour détecter un fonctionnement défectueux dans les blocs d'alimentation principaux sans contact 16 et 18, et un générateur de commande pour générer le signal de commande à partir de la détection du fonctionnement défectueux pour fermer au moins un ou tous les deuxièmes interrupteurs sous vide 14 montrés par exemple à la figure 1. Par ailleurs, le contrôleur a une entrée pour détecter un fonctionnement défectueux dans les premiers interrupteurs sous vide montrés par exemple à la figure 1 et un générateur de commande pour contrôler les deuxièmes moteurs contrôlables pour fermer au moins un ou tous les deuxièmes interrupteurs sous vide 14 montrés par exemple à la figure 1 à la détection d'un fonctionnement défectueux dans un des premiers interrupteurs sous vide.

Si on se réfère maintenant aux figures 1, 3 et 4, dans le cas d'une explosion dans un des premiers interrupteurs sous vide 10, ce qui est peu probable si le système est bien conçu, le deuxième interrupteur sous vide 14 associé au premier interrupteur sous vide qui a explosé est fermé et l'amplitude maximale de modulation d'impédance est réduite par epsilon. Les deuxièmes interrupteurs sous vide 14 sont utilisés en tant que shunts. Epsilon est petit et est une fonction du nombre de tronçons en service dans la ligne de transport d'énergie électrique qui peut avoir une longueur de 200 kilomètres. Plus le nombre de tronçon est élevé, plus epsilon est petit. Si un interrupteur sous vide est sujet à un fonctionnement défectueux, la ligne demeure en opération. Le remplacement d'un appareil de commutation partiellement défectueux prend moins d'une journée et ceci peut être fait sans interruption de service. A l'exception d'une mauvaise conception non intentionnelle, la ligne de transport d'énergie électrique ne perdra pas sa capacité de transport. Dans le cas d'un fonctionnement défectueux d'un des premiers interrupteurs sous vide 10, le deuxième interrupteur sous vide 14 prend automatiquement la relève.

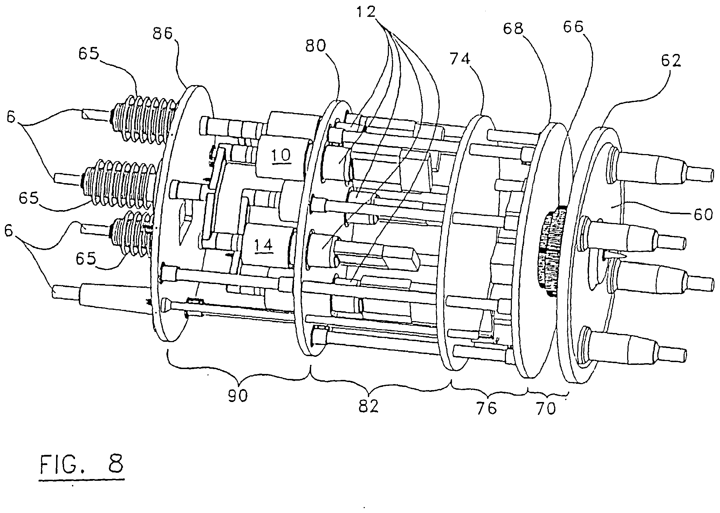

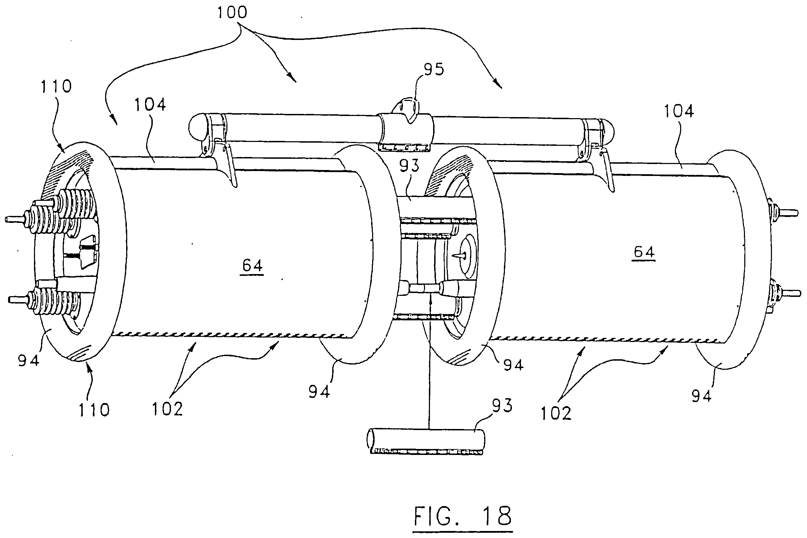

Nous nous référerons maintenant aux figures 2, et 7 à 17, pour décrire un mode de réalisation préféré de l'appareil de commutation. L'appareil de commutation comprend généralement à une extrémité une première plaque conductrice 60 isolée au moyen d'un isolateur 62 de la paroi latérale 64 du boîtier montré à la figure 18. Cette première plaque conductrice 60 branche électriquement les quatre conducteurs de la ligne de phase. Le courant électrique des quatre conducteurs circule de la première plaque 60 à travers un conducteur central qui s'étend à travers des transformateurs de courant 66 et ensuite au travers d'une deuxième plaque conductrice 68. Ces deux plaques conductrices 60 et 68 délimitent un premier compartiment 70 qui contient les transformateurs 66. Les transformateurs 66 sont utilisés pour mesurer le courant de phase, pour extraire une alimentation électrique de la ligne de phase, et comme une antenne émettrice et réceptrice pour le système de communication de ligne de transport d'énergie électrique et le système de positionnement mondial (GPS).

Le courant électrique circule depuis cette deuxième plaque conductrice 68 à travers une série de conducteurs 72 situés en périphérie de cette seconde plaque 68 vers une troisième plaque conductrice 74. Ces deuxièmes et troisièmes plaques conductrices 68 et 74 délimitent un deuxième compartiment 76 pour loger le contrôleur et les blocs d'alimentation. Cette configuration réduit le champ magnétique produit par le courant de phase à l'intérieur de ce deuxième compartiment 76, et aussi dans les compartiments 82 et 90.

Ensuite, le courant électrique circule depuis cette troisième plaque 74 à travers des conducteurs 78 situés en périphérie de cette troisième plaque 74 pour atteindre une quatrième plaque conductrice 80. Ces troisièmes et quatrièmes plaques conductrices 74 et 80 délimitent un troisième compartiment 82 qui contient les organes de commande. Chaque organe de commande comprend un moteur, un convertisseur et des dispositifs de commandes mécaniques associés. Ces organes de commande sont des moteurs contrôlables pour ouvrir et fermer les interrupteurs sous vide. La quatrième plaque conductrice 80 est utilisée comme une référence de tension pour tous les interrupteurs sous vide. La quatrième plaque conductrice 80 est branchée à une cinquième plaque conductrice 86 par les conducteurs 84 situés en périphérie de cette quatrième plaque conductrice 80. La cinquième plaque conductrice 86 est la plaque de sortie de l'appareil de commutation. Les quatrièmes et cinquièmes plaques conductrices 80 et 86 délimitent un quatrième compartiment 90 qui contient les interrupteurs qui sont les interrupteurs sous vide. La cinquième plaque conductrice 86 contient des traversées d'isolateur 65 pour le passage des conducteurs 6, une porte 92 pour réduire la surpression en cas d'explosion, une traversée d'isolateur 97, montré par exemple à la figure 22, pour une alimentation électrique capacitive et les isolateurs 97 montrés par exemple à la figure 22, lorsque requis.

Donc, l'appareil de commutation comprend un boîtier ayant une paroi latérale conductrice 64 montrée à la figure 18, et des première, deuxième, troisième, quatrième et cinquième plaques conductrices 60, 68, 74, 80 et 86 transversales à la paroi latérale et qui sépare le boîtier en premier, deuxième, troisième et quatrième compartiments 70, 76, 82 et 90. La première plaque conductrice 60 comprenant un élément isolant 62 pour isolation électrique de la paroi latérale. Les deuxième, troisième, quatrième et cinquième plaques conductrices transversales 68, 74, 80 et 86 sont branchées électriquement à la paroi latérale. Les première, deuxième, troisième et quatrième plaques conductrices 60, 68, 74 et 80 sont branchées électriquement au conducteur 6 et la cinquième plaque conductrice 86 est isolée de certains des conducteurs 6 au moyen de traversées d'isolateur 65. Les premières et deuxièmes plaques conductrices délimitent le premier compartiment 70 qui comprend au moins un conducteur central branchant les première et deuxième plaques, et des transformateurs 66 situés autour du conducteur central pour informer le contrôleur du courant circulant dans le conducteur central. Les deuxième et troisième plaques délimitent le deuxième compartiment 76 qui inclut le contrôleur et des blocs d'alimentation dédiés et principaux sans contact. Les troisième et quatrième plaques délimitent le troisième compartiment 82 qui inclut les moteurs contrôlables 12. Les quatrième et cinquième plaques délimitent le quatrième compartiment 90 qui inclut les interrupteurs sous vide 10 et 14. Selon un mode de réalisation préféré, un écran mécanique 13 protège les interrupteurs sous vide les uns des autres.

Un des conducteurs 6 est directement branché à la plaque de sortie 86 de l'appareil par un lien galvanique. Les autres conducteurs sont branchés à travers des traversées d'isolateur 65 pour entrer dans le quatrième compartiment 90 qui contient les interrupteurs sous vide. Dans ce mode de réalisation, les interrupteurs sous vide sont prévus en paires et sont branchés en parallèle comme montré plus spécifiquement à la figure 9. Les interrupteurs sous vide sont branchés à la plaque de référence de tension ou au boîtier de l'appareil. Pour chaque paire d'interrupteurs sous vide, le deuxième interrupteur sous vide 14 est utilisé comme un shunt et est branché au dispositif "déclencheur associé". À la figure 9, l'écran 13 de l'interrupteur 10 a été enlevé pour fournir une vue des éléments apparaissant derrière l'écran 13. Les transformateurs de courant 9 branchés au contrôleur sont aussi prévus pour mesurer des courants. Des détecteurs de tension capacitifs 63 sont aussi prévus pour mesurer des tensions.

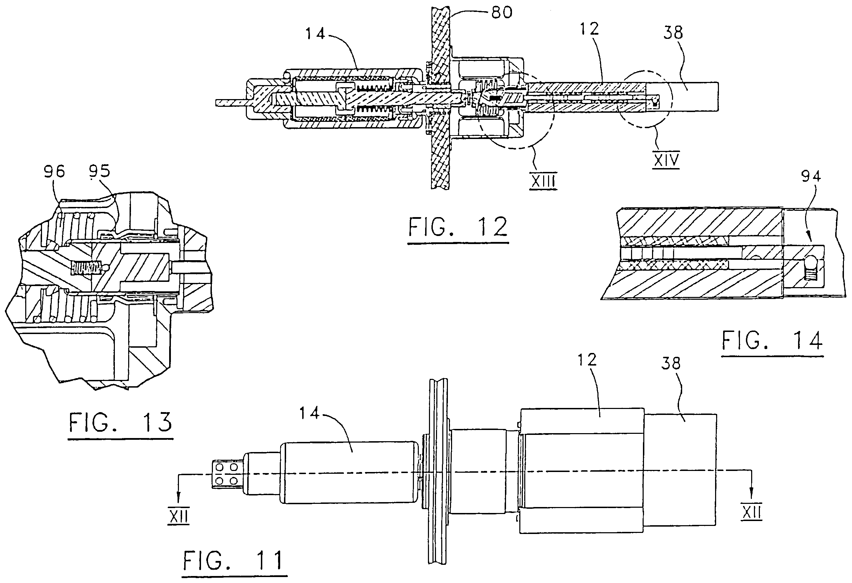

Si on se réfère maintenant plus spécifiquement aux figures 11 à 14, chacun des deuxièmes moteurs contrôlables 12 comprend un mécanisme de stabilisation 94 pour stabiliser la position du deuxième moteur contrôlable 12 en position ouverte ou fermée. Un ressort 96 est prévu pour contraindre le deuxième interrupteur en position fermée. Un mécanisme de blocage est prévu pour maintenir le ressort dans une position compressée pour maintenir l'interrupteur en position ouverte. Soit l'activation du convertisseur 38 soit la fermeture de l'interrupteur contrôlable 50 montrés à la figure 6 est suffisant pour activer le moteur 12 pour maîtriser le mécanisme de stabilisation 94 et ouvrir le mécanisme de blocage 95. Le ressort, une fois le mécanisme de blocage 95 ouvert, déplace le deuxième interrupteur 14 en position fermée. Lorsque l'organe de commande linéaire est activé pour ouvrir le deuxième interrupteur sous vide 14, le mécanisme de blocage 95 maintient l'interrupteur sous vide 14 dans une position ouverte. Si le convertisseur 38 ou le bloc d'alimentation qui alimente le convertisseur 38 ne fonctionne pas, et que le contrôleur demande la fermeture de l'interrupteur 14, alors le dispositif "déclencheur associé" 42 injectera un courant dans la bobine du moteur pour maîtriser le mécanisme de stabilisation 94 pour ouvrir le mécanisme de blocage 95 et ainsi le ressort 96 fermera l'interrupteur sous vide 94.

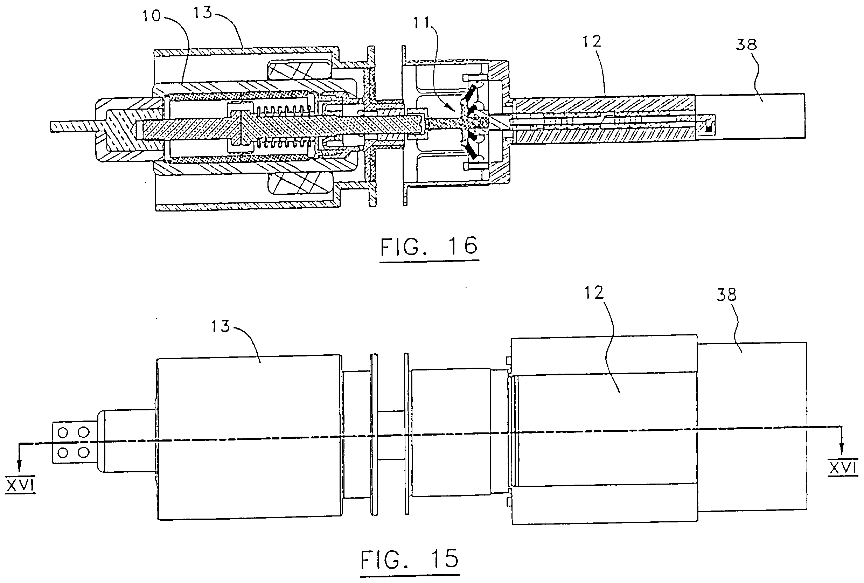

Si on réfère maintenant aux figures 15 et 16, le premier interrupteur sous vide 10 branché en parallèle avec le deuxième interrupteur sous vide 14 est activé par un moteur 12 ayant un dispositif bistable 11 ayant deux positions stables, ouverte ou fermée, et un moteur linéaire 12 tel que montré plus spécifiquement à la figure 16. Ce premier interrupteur sous vide 10 est utilisé pour court-circuiter ou ouvrir le conducteur correspondant.

Les moteurs linéaires 12 qui ouvrent et ferment les deuxièmes interrupteurs sous vide 14 sont faits d'un bobinage monophasé libre de bouger à l'intérieur d'un champ magnétique orthogonal à un champ magnétique. Une source de tension alimente le bobinage du moteur à travers le convertisseur 38. Tel que montré à la figure 6, chaque dispositif "déclencheur associé" 42 comprend un bloc d'alimentation indépendant pour chacun des moteurs linéaires 12 et son interrupteur sous vide associé. Ces blocs d'alimentation indépendants rechargent les condensateurs 48 qui sont branchés au bobinage des moteurs à travers des interrupteurs électromagnétiques ou électroniques 50. Lors d'un fonctionnement défectueux du contrôleur, le bloc d'alimentation ou le convertisseur de moteur, alors des interrupteurs 50 du dispositif "déclencheur associé" sont forcés en position fermée. L'énergie accumulée par un condensateur 48 induit un courant électrique à travers le bobinage du moteur correspondant 12 selon une direction donnée pour produire un mouvement du moteur linéaire correspondant. Ce mouvement maîtrise le mécanisme de stabilisation 94, ouvre le mécanisme de blocage 95 et ainsi le ressort 96 ferme l'interrupteur sous vide correspondant 14. Lorsque tous les deuxièmes interrupteurs sous vide 14 sont fermés alors la ligne de phase retrouve sa capacité originale de transport de courant. Les convertisseurs 38 alimentent les moteurs 12 avec l'énergie nécessaire pour ouvrir et fermer les deuxièmes interrupteurs sous vide. Aussi, les convertisseurs 38 et les moteurs 12 sont utilisés pour rompre en mode régénérateur ou pour réduire le mouvement de n'importe quel des interrupteurs sous vide.

Si on se réfère maintenant plus spécifiquement à la figure 17, on peut voir où la plupart des éléments montrés à la figure 5 sont situés dans le contexte des modes de réalisation montrés aux figures 2, et 7 à 17. Les blocs d'alimentation sans contact capacitifs comprennent des transformateurs de tension 15. Des alimentations capacitives 17 sont prévues. Le contrôleur 20 est mis en oeuvre par une carte de contrôle.

Si on se réfère maintenant à la figure 18, on peut voir un module de commutation 100 pour varier l'impédance de deux lignes de phase de deux tronçons adjacents d'une linge de transport d'énergie électrique. Chacune des lignes de phase comporte quatre conducteurs isolés électriquement les uns des autres et court-circuités à deux extrémités de leur tronçon. Le module de commutation comprend deux appareils de commutation chacun étant par exemple comme montré aux figures 1 à 4. Les deux appareils de commutation sont montés dos à dos. Le boîtier comprend des ouvertures 102 dans ses parties haute et basse pour ventilation. Les ouvertures dans la partie haute ne sont pas montrées parce qu'elles sont situées sous le demi cylindre 104. Le boîtier comprend un matériau d'isolation thermique pour prévenir une surchauffe par rayonnement solaire de l'intérieur du boîtier.

Le boîtier comprend une paroi cylindrique 64 comprenant à ses deux extrémités des anneaux de garde 94. Un crochet de levage 95 est aussi prévu. Les ouvertures situées au haut sont couvertes par le demi cylindre 104 qui dirige l'air pour ventilation dans les anneaux de garde 94 qui sont aussi pourvus d'ouvertures 110 situées en dessous et au-dessus. Un isolateur thermique est situé sous le cylindre pour prévenir une surchauffe par rayonnement solaire de l'intérieur du boîtier. Des raccords mécaniques sont présents entre l'appareil et le module 100.

Par la mise en oeuvre de deux appareils de commutation dans un module de commutation dos à dos 100, le nombre de pylônes qui seraient impliqués avec un appareil de commutation est réduit par un facteur 2. Pour un LIM de 30 km nominal ou un tronçon de déglaçage, seulement un pylône par 60 km à un LIM ou un module de commutation de déglaçage 100.

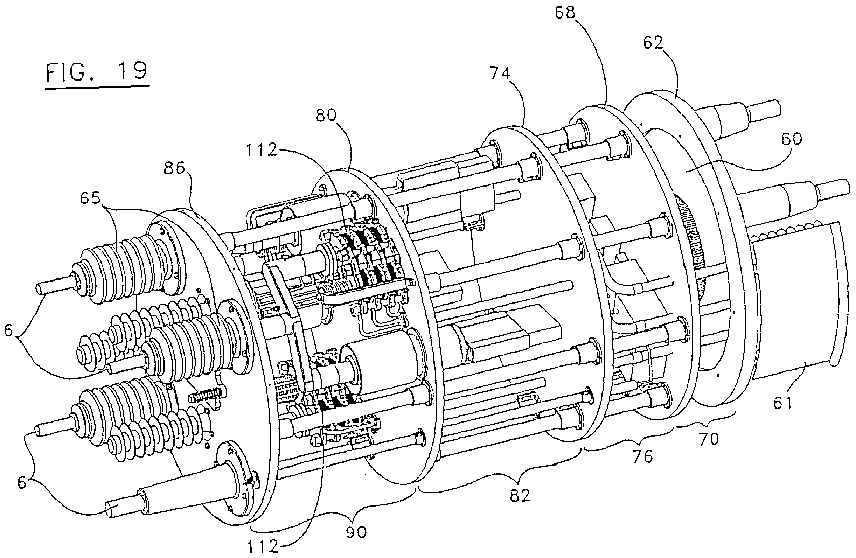

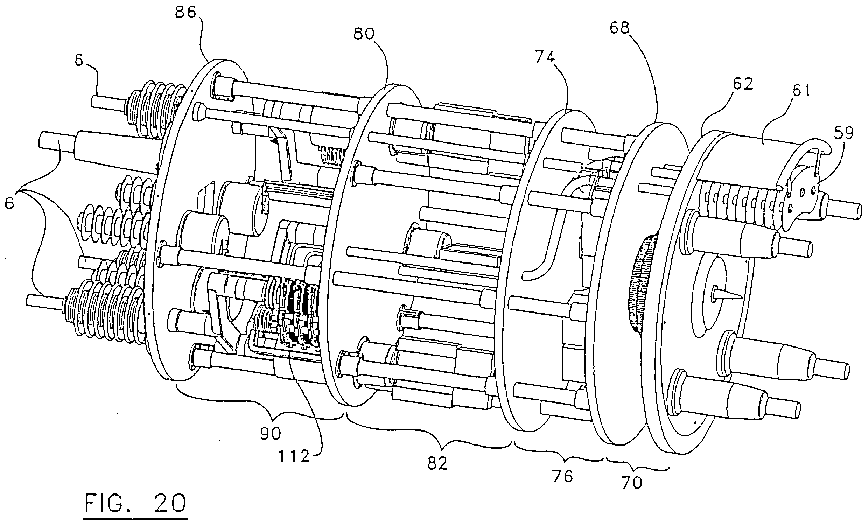

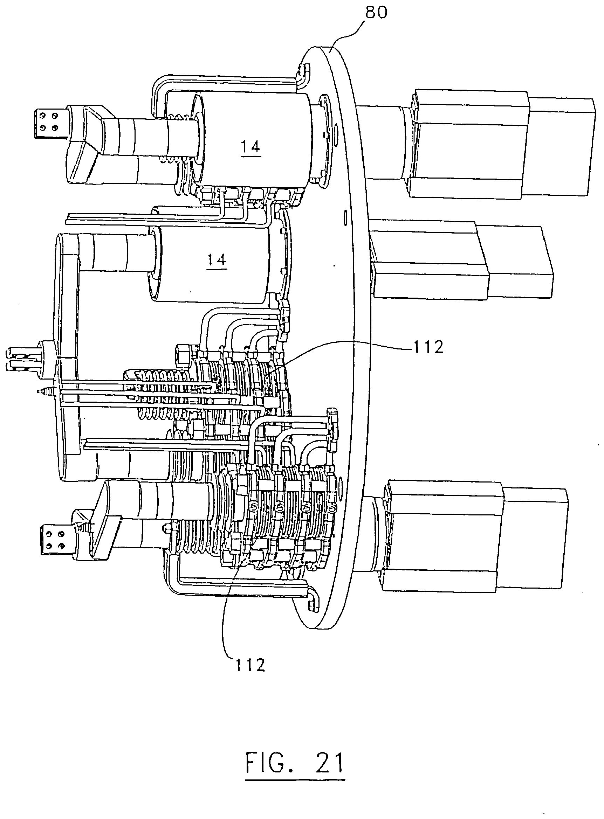

Si on se réfère maintenant aux figures 2, et 19 à 21, on peut voir un appareil de commutation comportant des interrupteurs électroniques 112. Lorsqu'on désire augmenter la fréquence d'ouverture et de fermeture, alors les premiers interrupteurs sous vide montrés à la figure 1 sont remplacés par des interrupteurs électroniques 26 branchés en parallèle avec les deuxièmes interrupteurs sous vide 14. Dans ce cas, des éléments additionnels devraient être ajoutés tel qu'un système de refroidissement avec un caloduc 59, un isolateur, un circuit de protection contre les surtensions, un circuit distributeur de tension (non illustré) pour distribuer la tension parmi les différents étages d'interrupteurs électroniques, et des cartes de commande 40 montrées à la figure 5. Un écran solaire 61 est présent pour une protection contre les rayons solaires.

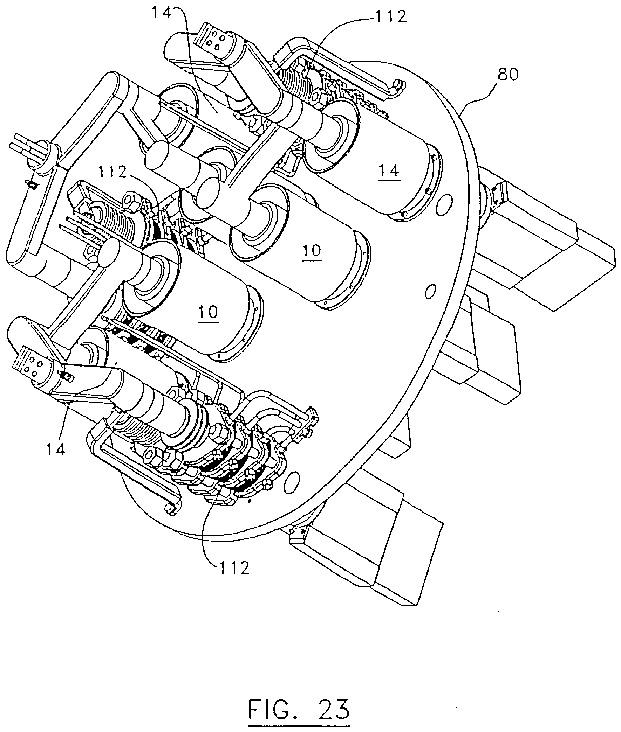

Si on se réfère maintenant aux figures 3, 22 et 23, on peut voir un appareil de commutation avec deux interrupteurs sous vide 10 et 14 et un interrupteur électronique 26 branché en parallèle. En ayant les premier et deuxième interrupteurs sous vide 10 et 14 branchés en parallèle avec un interrupteur électronique 26, l'opérateur a le choix d'utiliser soit le premier interrupteur sous vide 10 ou l'interrupteur électronique 112 pour commuter le conducteur correspondant.

Nous décrirons maintenant un mode de déblocage qui est un mode pour forcer l'ouverture d'un interrupteur sous vide. Lorsqu'un organe de commande linéaire est activé pour ouvrir un interrupteur sous vide et que cet interrupteur sous vide ne s'ouvre pas parce que, par exemple, ses contacts sont bloqués ensemble, alors un signal oscillant est superposé au signal de commande du moteur de façon à superposer une force de percussion à la force d'ouverture pour débloquer l'interrupteur sous vide correspondant.

Nous décrirons maintenant un mode d'opération ou une pression additionnelle peut être appliquée sur les contacts d'un interrupteur sous vide. Lors d'un fonctionnement défectueux de la mise à la terre, le courant de la ligne peut augmenter par plusieurs dizaines de kilos ampères avant que le disjoncteur de ligne ne corrige le problème, plusieurs dizaines de millisecondes plus tard. Au cours de cette période temps critique, il est possible de réduire d'avantage la résistance des contacts de l'interrupteur en additionnant à la force de fermeture des ressorts, la force produite par les moteurs linéaires pendant plusieurs dizaines de millisecondes. Selon ce mode d'opération, le courant de court circuit est détecté et un fort courant est appliqué au bobinage des moteurs linéaires au moyen des convertisseurs des moteurs afin de conserver les contacts des deuxièmes interrupteurs sous vide fermés aussi longtemps que le fonctionnement défectueux est détecté.

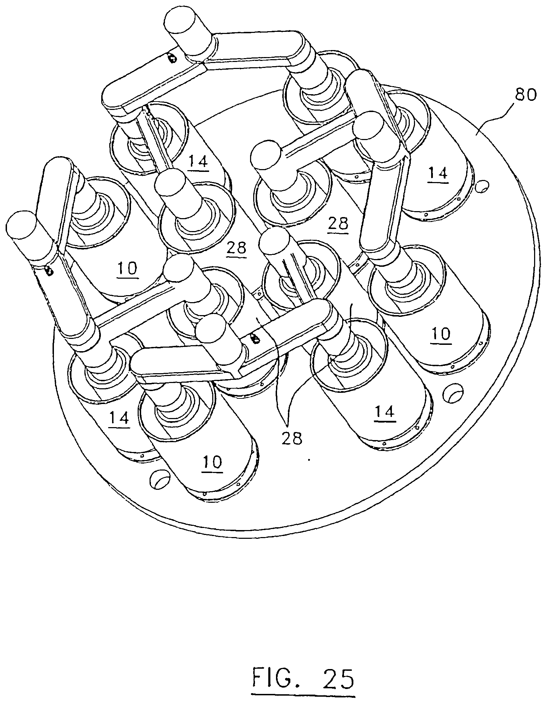

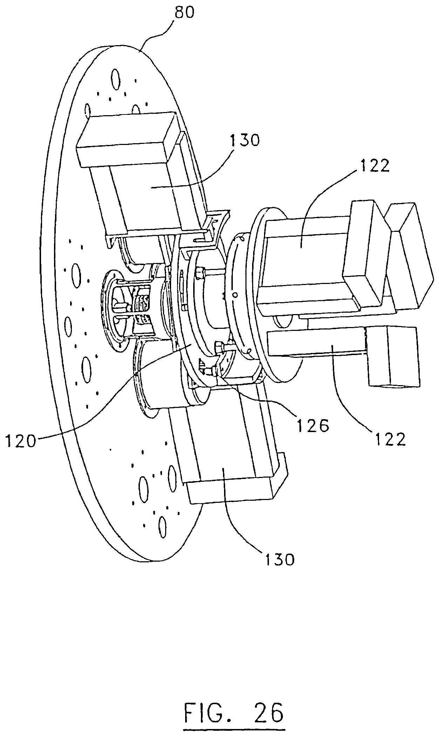

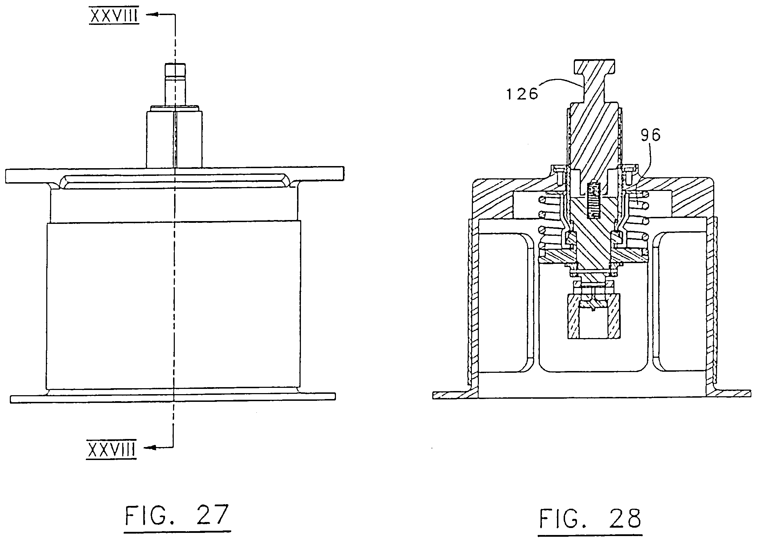

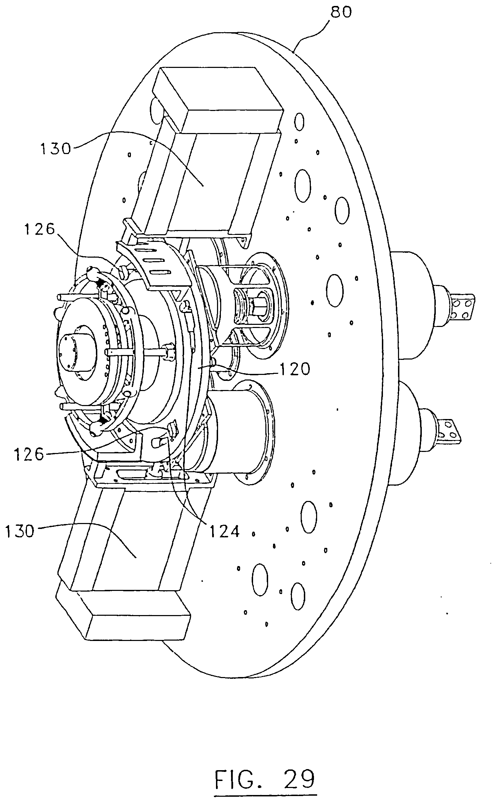

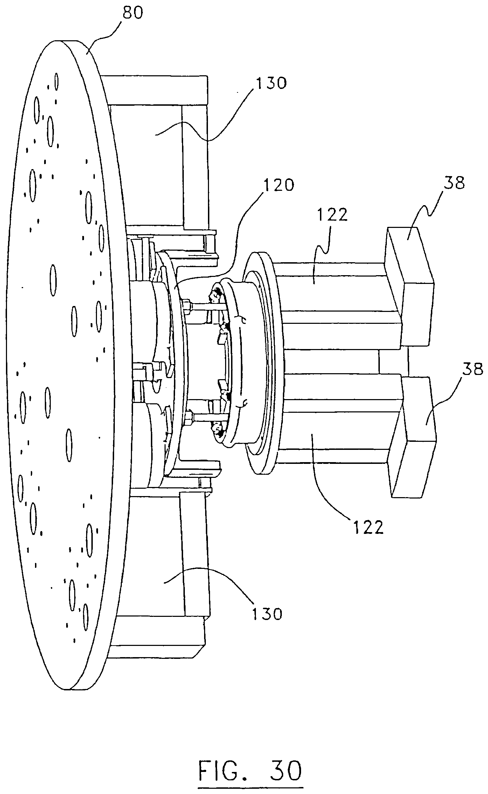

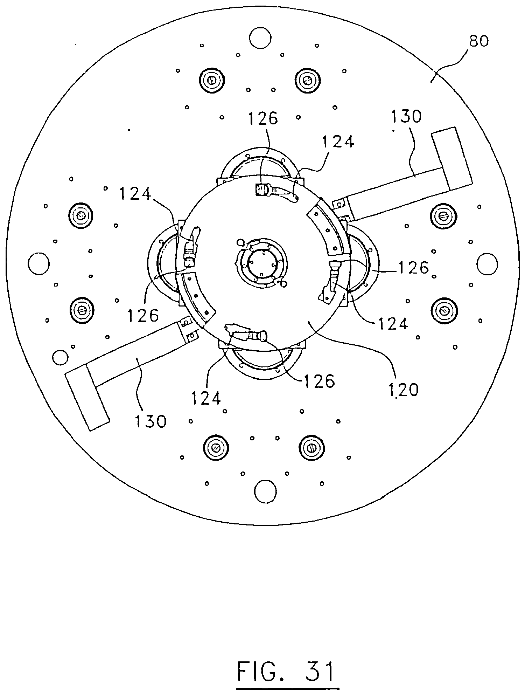

Si on se réfère maintenant aux figures 4, et 24 à 31, on peut voir un mode de réalisation pour le déglaçage. Nous décrirons un mode d'opération appelé "fermeture avant rupture". Dans ce mode, les quatre connecteurs de la ligne de phase ne peuvent être ouverts simultanément de façon à ce que la ligne de phase ne soit jamais complètement ouverte. Selon ce mode de réalisation, l'appareil comprend quatre interrupteurs sous vide 28 qui sont branchés à un dispositif "fermeture avant rupture", et quatre deuxièmes interrupteurs sous vide 14 qui sont branchés en parallèle aux quatre premiers interrupteurs sous vide 10. Les deuxièmes interrupteurs sous vide 14 sont utilisés comme shunts. En variant la position d'opération du dispositif "fermeture avant rupture", l'interrupteur sous vide 28 qui est fermé est commuté de façon circulaire.

Le dispositif "fermeture avant rupture" comprend une plaque qui est un disque de levage 120 activé par un ou plusieurs moteurs de levage 122. Ce disque 120 est programmé et pourvu d'ouvertures 124 à travers lesquelles des tiges 126 passent. Les tiges 126 ont des formes géométriques prédéterminées complémentaires aux formes des ouvertures 124 dépendant de la position angulaire du disque. La position angulaire du disque permet de conserver en tout temps un des quatre interrupteurs sous vide 28 en position fermée. Des moteurs 130 tournent le disque dans une des quatre positions préétablies.

En bref, chacun des moteurs contrôlables a une tige branchée au troisième interrupteur sous vide correspondant 28, qui est mobile le long d'un parcours entre des positions ouverte et fermée. Une plaque mobile 120 est munie de quatre ouvertures permettant aux quatre tiges de traverser la plaque, les ouvertures de la plaque et des sections transversales des tiges ayant des formes complémentaires permettant le déplacement d'un maximum de trois interrupteurs sous vide 28 en position ouverte. Des moteurs de plaque contrôlables sont prévus pour tourner la plaque dans différentes positions d'opération perpendiculairement aux tiges pour déterminer lesquels des trois interrupteurs 28 peuvent se déplacer dans la position ouverte. Des moteurs 122 sont aussi prévus pour déplacer la plaque en parallèle avec les tiges déplaçant ainsi trois des quatre interrupteurs sous vide 28 entre des positions ouverte et fermée prévenant ainsi en tout temps une ouverture complète de la ligne de phase.

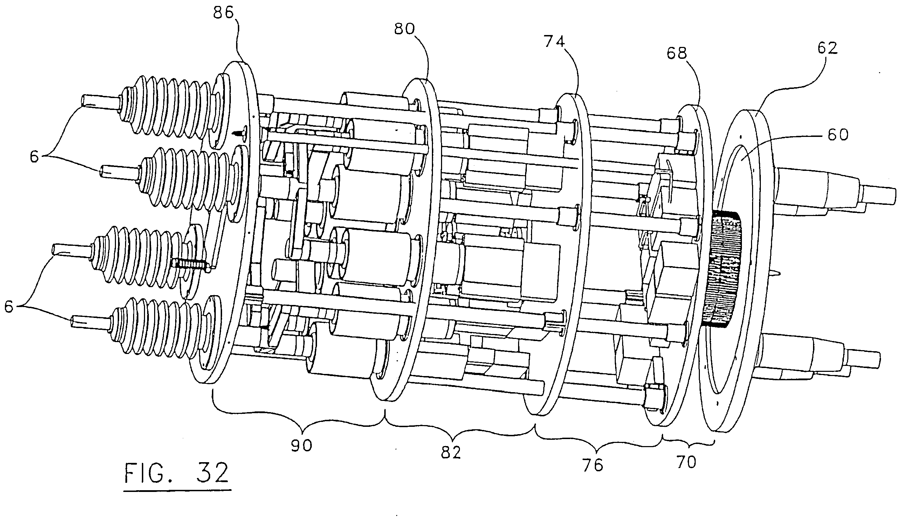

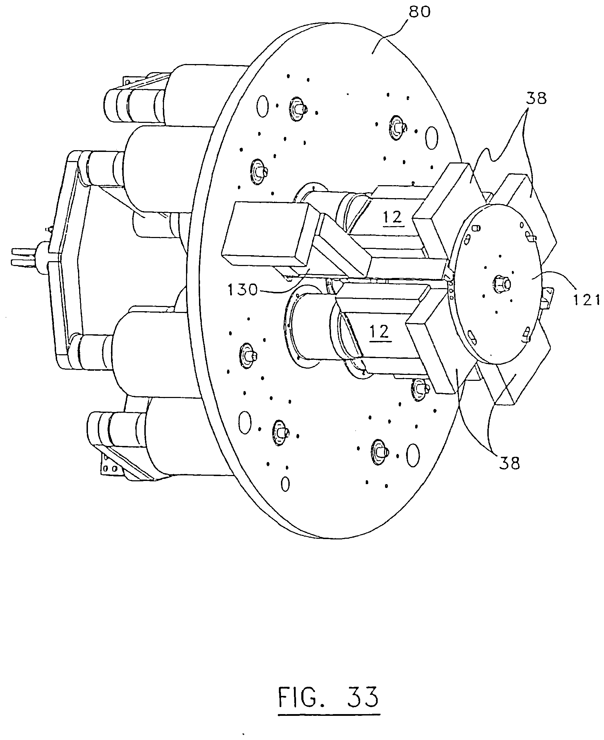

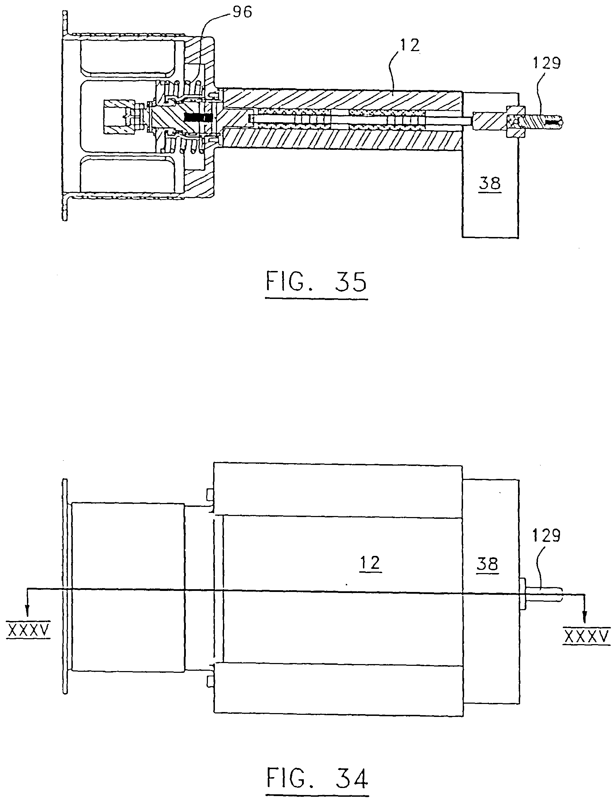

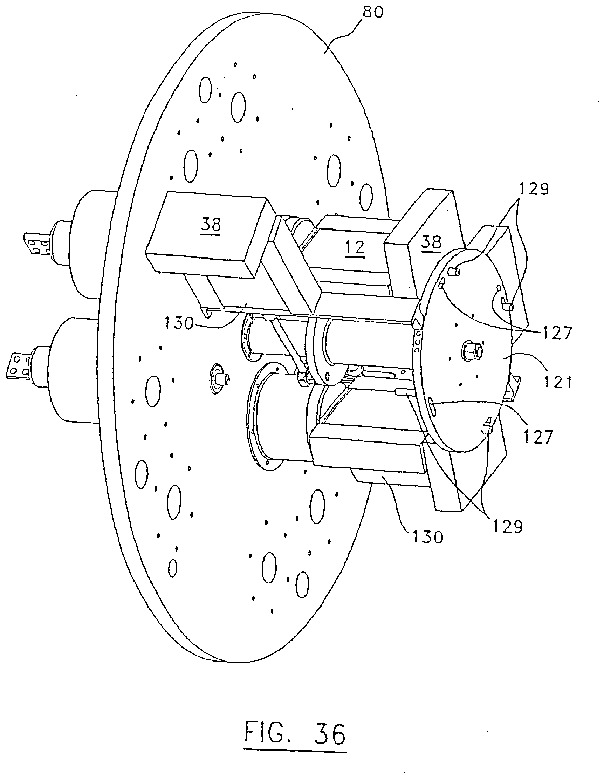

Si on se réfère aux figures 32 à 36, on peut voir un autre mode de réalisation du dispositif "fermeture avant rupture", qui est appelé "mécanisme de blocage". A la figure 36, un des moteurs 12 avec son convertisseur 38, le ressort 96 et les éléments associés ont été enlevés, lorsque comparé avec la figure 33, pour permettre une meilleure vue de certains éléments comme la broche 129. Dans ce mode de réalisation, quatre moteurs linéaires sont présents et sont associés respectivement aux quatre troisièmes interrupteurs sous vide 28 et au disque de blocage 121.

Le disque de blocage 121 est pourvu d'ouvertures 127 ayant différentes formes géométriques, à travers desquelles les broches 129 passent. La coopération entre les formes géométriques des ouvertures 127 et des broches 129 dépend de la position angulaire du disque 121 qui prévient, en tout temps, une ouverture simultanée des quatre troisièmes interrupteurs sous vide 28. Les moteurs 130 tournent le disque 121 dans une des quatre positions possibles préétablies de façon à diriger le courant dans un des conducteurs de la ligne de phase. Dans ce mode de réalisation, pour chaque conducteur, trois interrupteurs sous vide sont branchés en parallèle. Les interrupteurs sous vide 28 sont les interrupteurs sous vide du dispositif "fermeture avant rupture". Les deuxièmes interrupteurs sous vide 14 sont utilisés comme shunts et les premiers interrupteurs sous vide 10 sont utilisés pour ouvrir et fermer les conducteurs. Les deuxième et troisième interrupteurs sous vide sont prévus pour des raisons de sécurité. Pour déglacer un conducteur, ses trois interrupteurs sous vide correspondants sont fermés.

En bref, chacun des quatre moteurs contrôlables a une broche branchée au troisième interrupteur sous vide 28 correspondant qui est mobile le long d'un parcours entre des positions ouverte et fermée. Un disque mobile 121 est pourvu d'ouvertures 127 permettant aux broches 129 de traverser le disque, les ouvertures du disque et les broches coopérant pour permettre le déplacement d'un maximum de trois des quatre interrupteurs sous vide 28 en position ouverte. Des moteurs de plaque contrôlable 130 sont prévus pour déplacer le disque 121 dans différentes positions d'opération par rapport aux broches pour déterminer lesquels des trois interrupteurs 28 peuvent se déplacer dans la position ouverte prévenant ainsi à tout moment une ouverture complète de la ligne de phase, les moteurs de plaque contrôlables 130 étant commandés par le contrôleur.

Nous décrirons maintenant une procédure possible pour le déglaçage des quatre conducteurs d'une ligne de phase. Tout d'abord, les douze interrupteurs sous vide de l'appareil de commutation sont fermés. A tout moment, la tension et les courants des conducteurs de la ligne de phase sont mesurés. Premièrement, le conducteur ayant à être déglacé est sélectionné. Deuxièmement, le disque est tourné de façon à ce que l'interrupteur sous vide associé avec le conducteur devant être déglacé ne puisse être ouvert. Troisièmement, les trois interrupteurs sous vide restants du dispositif "fermeture avant rupture" sont ouverts. Quatrièmement, le contrôleur vérifie que les étapes précédentes ont été exécutées correctement en détectant les enclenchements et en mesurant le courant électrique traversant les conducteurs. Cinquièmement, les trois interrupteurs sous vide utilisés comme shunts et correspondant aux trois interrupteurs sous vide du dispositif "fermeture avant rupture" qui sont ouverts sont aussi ouverts selon une séquence prédéterminée. Sixièmement, le contrôleur vérifie que les étapes précédentes ont été exécutées correctement en détectant les enclenchements et en mesurant le courant électrique traversant les conducteurs de la ligne de phase. Septièmement, les trois interrupteurs sous vide restants correspondant à ceux du dispositif "fermeture avant rupture" qui sont ouverts sont aussi ouverts selon une séquence préétablie. Huitièmement, le contrôleur vérifie que les étapes précédentes ont été exécutées correctement en détectant les enclenchements et en mesurant les tensions et les courants des conducteurs de la ligne de phase. A ce moment, on peut considérer que le déglaçage d'un des conducteurs est commencé.

Si un problème est détecté par le contrôleur, un rapport est émis et l'opération de déglaçage est interrompue. Une fois que les détecteurs de charge montés sur les palonniers confirment que le déglaçage du conducteur sélectionné est complété, alors les étapes mentionnées précédemment sont exécutées dans l'ordre inverse de façon à fermer tous les interrupteurs sous vide. Ces étapes peuvent ensuite être exécutées à nouveau en sélectionnant un autre des conducteurs à être déglacé.

De façon à prévenir une rotation du faisceau de conducteurs lorsqu'un déglaçage est effectué, une séquence de déglaçage est choisie de façon à conserver le centre de masse du faisceau sous le centre géométrique du faisceau. Par exemple, deux conducteurs supérieurs et un conducteur inférieur sont déglacés selon une séquence, ensuite les deux conducteurs supérieurs et l'autre conducteur inférieur sont déglacés selon une séquence. Cette routine est exécutée jusqu'à ce que tous les conducteurs soient déglacés.

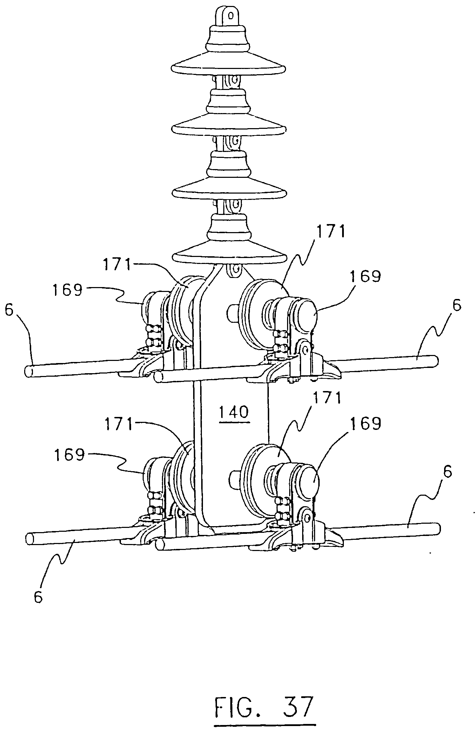

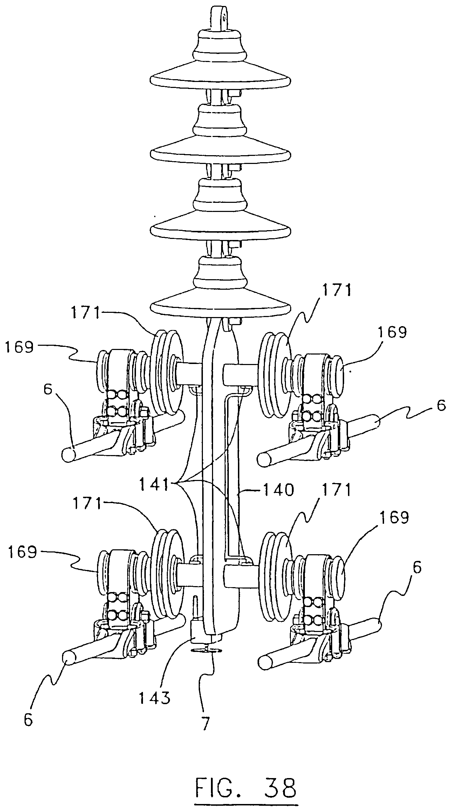

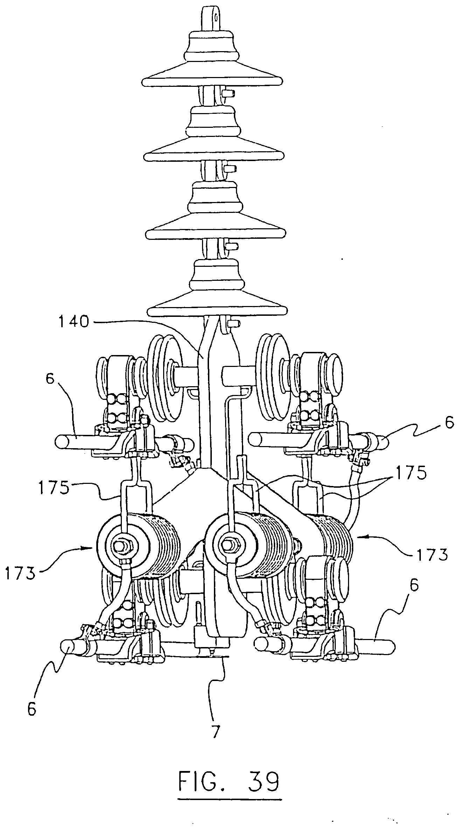

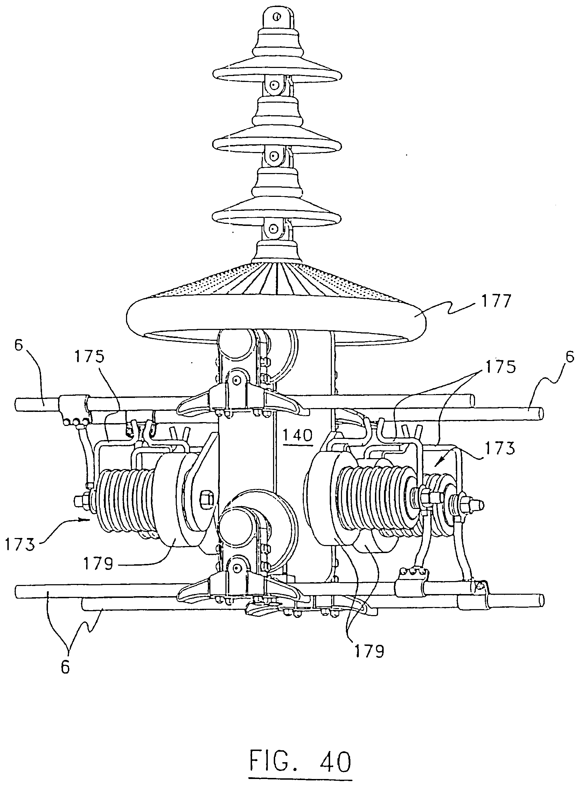

Si on se réfère maintenant aux figures 37 à 40, on peut voir qu'il y a différents palonniers qui sont utilisés pour isoler les conducteurs d'un faisceau. Les palonniers 140 peuvent être utilisés pour monter sur ceux-ci des dispositifs de sécurité pour prévenir le traitement de surtension depuis une mise à la terre ou entre des phases ayant un problème, ou des problèmes résultant d'un éclair. Pour protéger les entretoises, les palonniers et les interrupteurs contre les surtensions, des brides de serrage en tension tels qu'une protection à semi-conducteur 173 ou des éclateurs 175 seuls ou en combinaison peuvent être installés. Des éclateurs activés au moyen d'un transformateur de courant 179 montrés à la figure 40, alimentés par le courant circulant à travers une protection à semi-conducteur 173 peuvent être utilisés. Les éclateurs peuvent être des éclateurs à air ou des éclateurs sous vide, et peuvent être déclenchés, ou non, au moyen du transformateur de courant. Le palonnier peut aussi être utilisé pour mesurer la charge de glace sur chacun des conducteurs de la ligne de phase pour fins de déglaçage. L'information sur la charge de glace détectée par une cellule charge 141 est transmise au moyen d'un émetteur 143 alimentés de façon discontinue au moyen d'un bloc d'alimentation sans contact capacitif qui est pourvu d'une antenne capacitive 7. Des isolateurs 171 sont prévus. Des couvercles métalliques 169 sont montés sur les isolateurs 171. Une bague de protection à jupe de survolteur 177 montrée à la figure 40 peut aussi être présente.

Lorsqu'une surtension entre les conducteurs de la ligne de phase survient à cause d'un fonctionnement défectueux de la mise à la terre, d'éclairs ou d'autres raisons, des mécanismes de protection sont auto activés. Ces limiteurs de tension à semi conducteur montés sur les palonniers sont les premiers à être auto activés ensuite les éclateurs sont auto activés et finalement, plusieurs millisecondes plus tard, les interrupteurs sous vide des conducteurs sont fermés. Lorsque des interrupteurs électroniques sont utilisés, un limiteur de tension additionnel est ajouté près de chacun des interrupteurs électroniques et cet interrupteur électronique de voltage peut être fermé au moyen d'un système de fermeture automatique lorsqu'un fonctionnement défectueux survient. Finalement, les interrupteurs sous vide utilisés comme shunts sont fermés plusieurs dizaines de millisecondes plus tard.

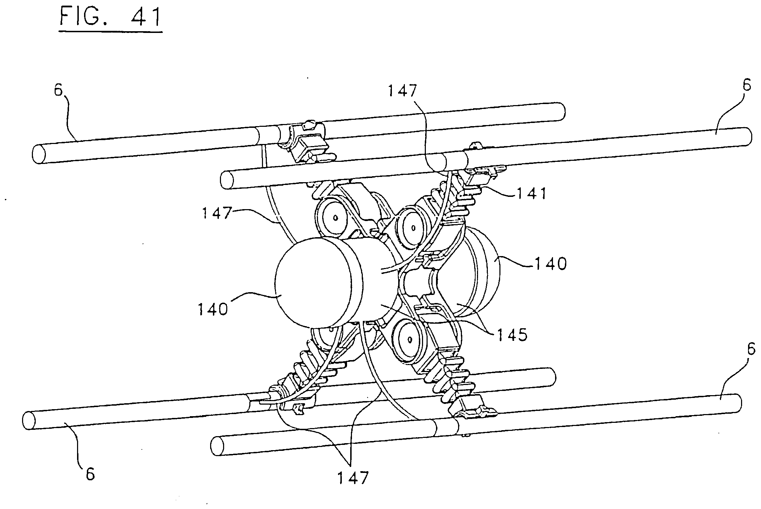

Si on se réfère maintenant à la figure 41, lorsqu'un tronçon d'une ligne de transport d'énergie électrique est situé au-dessus d'une route, d'une autoroute ou d'une rivière, ce tronçon peut être pourvu d'une lumière d'urgence 140 qui est activée lorsque le tronçon en question est en cours de déglaçage. Cette lumière d'urgence est montée entre les quatre conducteurs de la ligne de phase sur une entretoise isolée 141. La lumière d'urgence est alimentée au moyen d'un bloc d'alimentation qui est alimenté par la différence de voltage qui est présente entre les conducteurs au moyen de câbles 147 lorsque le tronçon de la ligne de transport d'énergie électrique est en procédure de déglaçage. La lumière d'urgence pourrait utiliser un émetteur de lumière à semi conducteur.

Si on se réfère maintenant à la figure 42, on peut voir une antenne 142 de blocs d'alimentation sans contact capacitifs de l'appareil de commutation. L'antenne 142 est montée sur l'entretoise 141 au moyen d'isolateurs électriques 151.

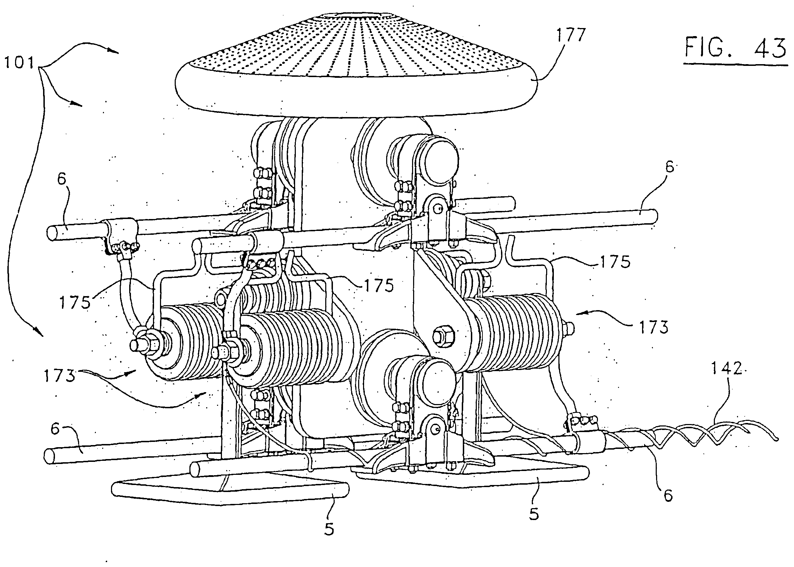

Si on se réfère maintenant à la figure 43, on peut voir un circuit de protection de surtension avec un bloc d'alimentation sans contact. Le circuit de protection comprend des brides de serrage en tension 173, des éclateurs 175 et une bague de protection à jupe de survolteur 177. Le bloc d'alimentation sans contact comprend une plaque qui est l'antenne capacitive 5. Cette antenne 5 est branchée à l'appareil de commutation via des câbles 142 et des traversées d'isolateur 97 montrés par exemple à la figure 22.

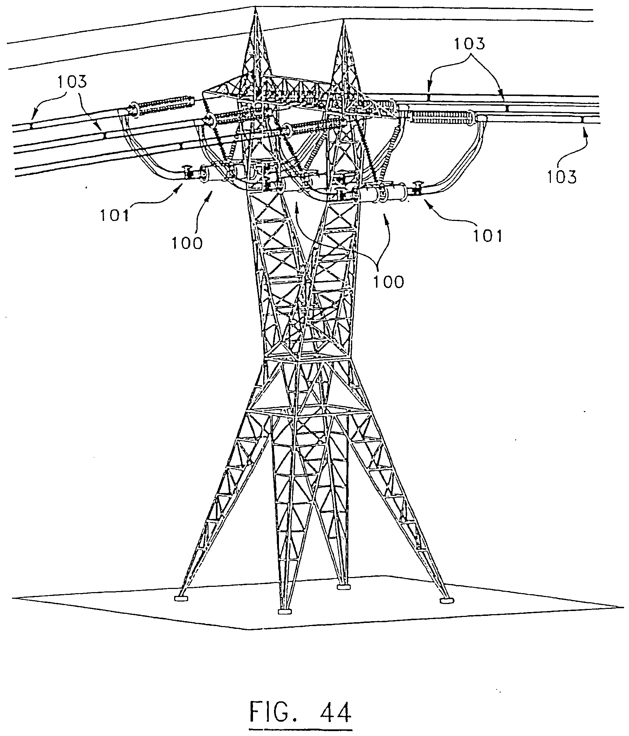

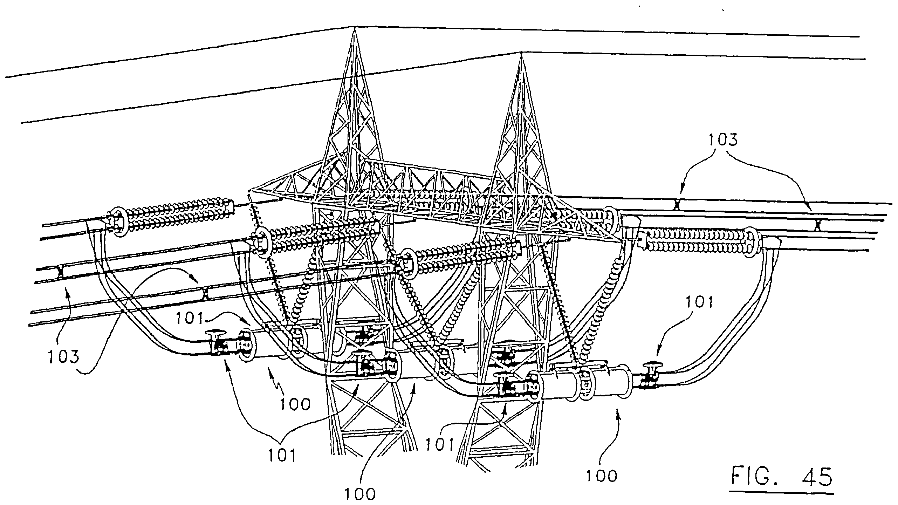

Si on se réfère maintenant aux figures 44 et 45, on peut voir le module de commutation 100 qui comprend deux appareils de commutation montés dos à dos. Ces figures 44 et 45 montrent aussi où le circuit de protection de surtension avec le bloc d'alimentation sans contact 101 montré à la figure 43 est monté par rapport au module 100 et aux entretoises 103.

Si on se réfère maintenant aux figures 4, 5 et 6, nous décrirons selon un mode de réalisation préférentiel, une méthode pour varier l'impédance d'une ligne de phase d'un tronçon 2 d'une ligne de transport d'énergie électrique 4. La ligne de phase comprend quatre conducteurs 6 isolés électriquement les uns des autres et court-circuités entre eux à deux extrémités du tronçon. La méthode comprend les étapes de a) fournir quatre premiers interrupteurs sous vide 10 branchés en série avec les quatre conducteurs 6; b) fournir quatre premiers moteurs contrôlables 12 pour ouvrir et fermer de façon sélective les premiers interrupteurs sous vide; c) détecter un paramètre représentatif des conditions d'opérations courantes de la ligne de phase; d) commander les premiers moteurs contrôlables en fonction du paramètre détecté à l'étape c); e) fournir quatre deuxièmes interrupteurs sous vide 14 branchés en parallèle respectivement avec les premiers interrupteurs sous vide; et f) ouvrir et fermer de façon sélective les deuxièmes interrupteurs sous vide au moyen des deuxièmes moteurs contrôlables 12, les deuxièmes moteurs contrôlables étant commandés par l'étape de commander d).

La méthode comprend en outre, pour chacun des deuxièmes moteurs contrôlables, les étapes de: g) fournir un bloc d'alimentation dédié sans contact 44 pour alimenter une alimentation électrique à partir de la ligne de phase; h) redresser l'alimentation électrique au moyen d'un redresseur 46; i) accumuler de l'énergie électrique à partir d'une sortie du redresseur à l'aide d'un condensateur 48; et j) décharger le condensateur 48 dans le deuxième moteur contrôlable correspondant pour fermer ledit deuxième moteur contrôlable, sur réception du signal de commande généré par l'étape de commander d).

Toujours selon un mode de réalisation préféré, une méthode est prévue selon laquelle l'étape c) comprend en outre: une étape de détecter si les interrupteurs sous vide qui devaient être ouverts en réponse à l'étape de commander d) sont ouverts, et émettre un signal d'avertissement lorsque ce n'est pas le cas; et l'étape d) de commander comprend en outre une étape d'envoyer un signal de commande oscillant pour les interrupteurs qui sont sujets à un signal d'avertissement pour forcer en position ouverte les interrupteurs en question.

L'appareil comprend également un dispositif de détection pour détecter les conditions d'opération courantes du tronçon de la ligne de transport d'énergie électrique. L'appareil comprend également un dispositif de commande pour commander les paires d'interrupteurs électromécanique et électronique en fonction des conditions d'opération. Les interrupteurs de chaque paire sont commandés de façon indépendante par des signaux de commande. Un mode de réalisation préféré du dispositif de commande sera décrit et montré en relation avec la figure 46.

En se référant maintenant à la figure 46, on peut voir un mode de réalisation préférentiel d'une unité qui comprend le dispositif de commande et une partie du dispositif de détection. L'unité comprend un processeur 570 ayant un premier port d'entrée 574 pour recevoir des signaux indicatifs des positions d'opération des interrupteurs, des seconds ports d'entrée 576 pour recevoir des signaux indicatifs des tensions aux bornes des paires d'interrupteurs, et des sorties 577 et 579 pour générer des signaux de commande. Le processeur 570 a des capacités de calcul pour calculer différentes valeurs relatives à des signaux détectés. Le dispositif comprend également un émetteur radiofréquence 566 branché au processeur 570 pour émettre des signaux indicatifs des positions d'opération des interrupteurs, et des tensions aux bornes des paires d'interrupteurs. Un récepteur radiofréquence 564 est également prévu. Le récepteur 564 et l'émetteur 566 sont respectivement munis d'antennes 568. Le récepteur 564 est branché au processeur 570 pour recevoir des signaux radiofréquences de commande à partir desquels les signaux de commande sont produits. L'unité comprend également un amplificateur 572 branché au processeur 570 pour commander le moteur 540 en fonction des signaux de commande.

Un dispositif d'alimentation électrique est prévu pour alimenter le processeur 570, le récepteur 564, l'émetteur 566 et l'amplificateur 572. Ce dispositif d'alimentation électrique comprend une première source d'alimentation électrique 578 comportant une batterie 582 et un capteur solaire 580 branché à la batterie 582. Ce dispositif d'alimentation électrique comprend également une seconde source d'alimentation électrique 581 branchée en parallèle à la première source d'alimentation électrique 578, et ayant des entrées 583 branchées aux conducteurs d'une ligne de phase. Ainsi, lorsqu'un des conducteurs est ouvert, l'alimentation peut se faire à partir de ce conducteur au moyen de l'alimentation 581 via une des entrées 583.

Le processeur 570 comprend également un port de communication 575 relié à un compte-tour de la vis mère 552 pour connaître sa position. Le port 574 du processeur 570 sert à recevoir un signal représentatif de la position du chariot du dispositif de commutation électromécanique qui regroupe les interrupteurs électromécaniques pour une même ligne de phase. La position du chariot est représentative de la position de chacun des interrupteurs électromécaniques qui y sont associés.

Le récepteur 564 et l'émetteur 566 permettent respectivement de recevoir et d'émettre des signaux radiofréquences. Les paires d'interrupteurs sont actionnés en fonction des signaux radiofréquences reçus. Les signaux radiofréquences émis par l'émetteur 66 permettent de confirmer la réception des signaux radiofréquences de commande et éventuellement l'exécution des commandes effectuées. Le récepteur 564 est apte en permanence à recevoir les signaux radiofréquences à distance qui sont codés.

Selon une façon préférentielle de procéder, on transmet un premier code contenant une identification d'une paire d'interrupteurs, une fenêtre de temps et ainsi qu'un mot de passe. Ensuite, on transmet un second code contenant une identification de la paire d'interrupteurs à actionner, la commande à effectuer, une information relative au temps à laquelle ladite commande doit être effectuée ainsi que le mot de passe. La commande associée au second code est effectuée seulement si le mot de passe du second code correspondant à celui du premier code, et si le temps d'exécution du second code est à l'intérieur de la fenêtre de temps définie dans le premier code.

L'émetteur 566 qui fonctionne de façon intermittente ou en continu confirme la commande reçue, le temps d'exécution de la commande, l'état des batteries et la tension dans les conducteurs. L'information relative à la tension aux bornes d'un conducteur ouvert permet en même temps de déterminer le courant qui passe à travers les autres conducteurs qui sont fermés. Un récepteur et un émetteur de zone qui ne sont pas illustrés sont également prévus pour recevoir des données de cellules de charge qui sont montées sur les lignes de phase et retransmettre les données reçues des cellules de charge à distance à un poste de commande central (non montré).

Selon un mode d'opération préféré, l'émetteur de la cellule de charge peut être mis en opération de façon intermittente pour transmettre différentes données sur demande ou à période fixe. Par exemple, un émetteur de 5 W pourrait fonctionner durant une milliseconde à toutes les quinze minutes.

## Revendications

1. Méthode pour localiser un événement survenu le long d'une ligne de phase sur un tronçon (1105) d'une ligne de transport d'énergie électrique, la ligne de phase comprenant n conducteurs (1001, 1002, 1003, 1004) isolés électriquement les uns des autres et court-circuités entre eux à deux extrémités du tronçon (1105), la méthode comprenant les étapes de:
a) surveiller un paramètre sur un des n conducteurs (1001, 1002, 1003, 1004) de la ligne de phase, à une des extrémités du tronçon (1105) sans référence à la masse, ledit paramètre étant représentatif de conditions d'opérations courantes de la ligne de phase et ayant une vitesse de propagation connue dans le conducteur (1001, 1002, 1003, 1004) ;
b) générer un signal de détection de l'événement à l'extrémité du tronçon (1105) à chaque fois que le paramètre a une valeur qui passe un seuil, et mémoriser un temps de réception lorsque le signal de détection est généré ;
c) émettre un signal représentatif d'une localisation géographique de l'extrémité du tronçon (1105) ; et
d) effectuer une localisation géographique de l'événement le long du tronçon (1105) une fois que deux signaux de détection consécutifs sont générés, à partir du signal représentatif de la localisation géographique de l'étape c), et des temps de réception associés aux deux signaux de détection consécutifs.

2. La méthode selon la revendication 1, dans laquelle l'étape de surveiller un paramètre sur un des n conducteurs (1001, 1002, 1003, 1004) de la ligne de phase est effectuée à une fréquence d'échantillonnage d'au moins 1 MHz.

3. La méthode selon l'une quelconque des revendications 1 et 2, dans laquelle dans l'étape a), des données sur le paramètre sont continuellement enregistrées dans une fenêtre de temps prédéterminée, et dans l'étape b), après la génération du signal de détection, les données produites à l'étape a) sont gardées en mémoire seulement sur une période de temps commençant 100 µs avant le temps de réception, et se terminant lorsque la valeur du paramètre repasse au-dessous du seuil.

4. La méthode selon l'une quelconque des revendications 1 à 3, dans laquelle ladite ligne de phase comprend 4 conducteurs (1001, 1002, 1003, 1004).

5. Appareil (1100) pour localiser un événement survenu le long d'une ligne de phase sur un tronçon (1105) d'une ligne de transport d'énergie électrique, la ligne de phase comprenant n conducteurs (1001, 1002, 1003, 1004) isolés électriquement les uns des autres et court-circuités entre eux à deux extrémités du tronçon (1105), l'appareil étant localisé à une des extrémités du tronçon (1105) et comprenant:
un dispositif de surveillance (570) d'au moins un paramètre sur un des n conducteurs (1001, 1002, 1003, 1004) de la ligne de phase sans référence à une masse, ledit au moins un paramètre étant représentatif de conditions d'opérations courantes de la ligne de phase et ayant une vitesse de propagation connue dans le conducteur (1001, 1002, 1003, 1004) ;
un dispositif (570) configuré pour générer un signal de détection de l'événement à l'extrémité du tronçon (1105) à chaque fois que ledit au moins un paramètre a une valeur qui passe un seuil, et mémoriser un temps de réception lorsque le signal de détection est généré;
un dispositif (570) configuré pour émettre un signal représentatif d'une localisation géographique de ladite extrémité du tronçon (1105) ; et
un dispositif (570) configuré pour effectuer une localisation géographique de l'événement le long du tronçon (1105) une fois que deux signaux de détection consécutifs sont générés, à partir du signal représentatif de la localisation géographique, et des temps de réception associés aux deux signaux de détection consécutifs.

6. Système comprenant deux appareils (1100, 1110), chaque appareil tel que revendiqué dans la revendication 5, un premier (1100) desdits deux appareils étant localisé sur un premier tronçon (1105), le deuxième (1110) desdits deux appareils étant localisé sur un deuxième tronçon (1115) adjacent au premier tronçon (1105), ledit deuxième appareil étant localisé à une extrémité du deuxième tronçon (1115) adjacente à l'extrémité du premier tronçon (1105) où est localisé le premier appareil (1100).

7. Appareil (1100) selon la revendication 5, dans lequel ledit dispositif de surveillance (570) étant apte à fonctionner à une fréquence d'échantillonnage d'au moins 1 MHz pour surveiller ledit au moins paramètre représentatif de conditions d'opérations.

8. Appareil (1100) selon l'une quelconque des revendications 5 et 7, ledit dispositif de surveillance (570) comprend des moyens pour enregistrer continuellement des données sur le paramètre dans une fenêtre de temps prédéterminée, et une mémoire pour garder en mémoire seulement les données sur une période de temps commençant 100 µs avant le temps de réception et se terminant lorsque la valeur dudit au moins un paramètre repasse au-dessous du seuil.

9. Appareil selon l'une quelconque des revendications 5, 7 et 8, ladite ligne de phase comprenant 4 conducteurs.

## Patentansprüche

1. Verfahren zum Lokalisieren eines Ereignisses, welches entlang einer Phasenleitung an einem Abschnitt (1105) einer Leitung zum Transport von elektrischer Energie auftritt, wobei die Phasenleitung n Leiter (1001, 1002, 1003, 1004) umfasst, welche voneinander elektrisch isoliert und an zwei Enden des Abschnitts (1105) untereinander kurzgeschlossen sind, wobei das Verfahren die Schritte umfasst:
a) Überwachen eines Parameters an einem der n Leiter (1001, 1002, 1003, 1004) der Phasenleitung, an einem der Enden des Abschnitts (1105) ohne Erdungsreferenz, wobei der Parameter aktuelle Betriebszustände der Phasenleitung repräsentiert und eine bekannte Ausbreitungsgeschwindigkeit in dem Leiter (1001, 1002, 1003, 1004) aufweist;
b) Erzeugen eines Detektionssignals des Ereignisses an dem Ende des Abschnitts (1105) bei jedem Mal, wenn der Parameter einen Wert aufweist, welcher einen Schwellenwert passiert, und Speichern einer Empfangszeit, wenn das Detektionssignal erzeugt wird;
c) Ausgeben eines Signals, welches eine geographische Lokalisierung des Endes des Abschnitts (1105) repräsentiert; und
d) Durchführen einer geographischen Lokalisierung des Ereignisses entlang des Abschnitts (1105) einmal, wenn zwei aufeinanderfolgende Detektionssignale erzeugt werden, ausgehend von dem Signal, welches die geographische Lokalisierung aus Schritt c) repräsentiert, und Empfangszeiten, welche den beiden aufeinanderfolgenden Detektionssignalen zugeordnet sind.

2. Verfahren nach Anspruch 1, wobei der Schritt des Überwachens eines Parameters an einem der n Leiter (1001, 1002, 1003, 1004) der Phasenleitung bei einer Abtastfrequenz von wenigstens 1 MHz durchgeführt wird.

3. Verfahren nach einem der Ansprüche 1 und 2, wobei in Schritt a) Daten über den Parameter kontinuierlich in einem vorbestimmten Zeitfenster aufgenommen werden, und in Schritt b) nach dem Erzeugen des Detektionssignals die in Schritt a) erzeugten Daten in einem Speicher lediglich in einer Zeitperiode vorgehalten werden, welche 100 µs vor der Empfangszeit beginnt und endet, wenn der Wert des Parameters erneut den Schwellenwert unterschreitet.

4. Verfahren nach einem der Ansprüche 1 bis 3, wobei die Phasenleitung 4 Leiter (1001, 1002, 1003, 1004) umfasst.

5. Vorrichtung (1100) zum Lokalisieren eines Ereignisses, welches entlang einer Phasenleitung an einem Abschnitt (1105) einer Leitung zum Transport von elektrischer Energie auftritt, wobei die Phasenleitung n Leiter (1001, 1002, 1003, 1004) umfasst, welche voneinander elektrisch isoliert und an zwei Enden des Abschnitts (1105) untereinander kurzgeschlossen sind, wobei die Vorrichtung an einem der Enden des Abschnitts (1105) angeordnet ist und umfasst:
eine Einrichtung zum Überwachen (570) von wenigstens einem Parameter an einem der n Leiter (1001, 1002, 1003, 1004) der Phasenleitung ohne Erdungsreferenz, wobei der wenigstens eine Parameter aktuelle Betriebszustände der Phasenleitung repräsentiert und eine bekannte Ausbreitungsgeschwindigkeit in dem Leiter (1001, 1002, 1003, 1004) aufweist;
eine Einrichtung (570), welche dazu eingerichtet ist, ein Detektionssignal des Ereignisses an dem Ende des Abschnitts (1105) bei jedem Mal zu erzeugen, wenn der Parameter einen Wert aufweist, welcher einen Schwellenwert passiert, und eine Empfangszeit zu speichern, wenn das Detektionssignal erzeugt wird;
eine Einrichtung (570), welche dazu eingerichtet ist, ein Signal auszugeben, welches eine geographische Lokalisierung des Endes des Abschnitts (1105) repräsentiert; und
eine Einrichtung (570), welche dazu eingerichtet ist, eine geographische Lokalisierung des Ereignisses entlang des Abschnitts (1105) einmal durchzuführen, wenn zwei aufeinanderfolgende Detektionssignale erzeugt werden, ausgehend von dem Signal, welches die geographische Lokalisierung repräsentiert, und Empfangszeiten, welche den beiden aufeinanderfolgenden Detektionssignalen zugeordnet sind.

6. System, umfassend zwei Vorrichtungen (1100, 1110), jede Vorrichtung wie in Anspruch 5 beansprucht, wobei eine erste (1100) der beiden Vorrichtungen an einem ersten Abschnitt (1105) lokalisiert ist, wobei die zweite (1110) der beiden Vorrichtungen an einem zweiten Abschnitt (1115) benachbart zu dem ersten Abschnitt (1105) lokalisiert ist, wobei die zweite Vorrichtung an einem Ende des zweiten Abschnitts (1115) benachbart zu dem Ende des ersten Abschnitts (1105) lokalisiert ist, wo die erste Vorrichtung (1100) lokalisiert ist.

7. Vorrichtung (1100) nach Anspruch 5, wobei die Einrichtung zum Überwachen (570) in der Lage ist, bei einer Abtastfrequenz von wenigstens 1 MHz zu arbeiten, um den wenigstens einen Parameter zu überwachen, welcher die Betriebszustände repräsentiert.

8. Vorrichtung (1100) nach einem der Ansprüche 5 bis 7, wobei die Einrichtung zum Überwachen (570) Mittel zum kontinuierlichen Speichern von Daten über den Parameter in einem vorbestimmten Zeitfenster umfasst, sowie einen Speicher, um lediglich die Daten aus einer Zeitperiode im Speicher vorzuhalten, welche 100 µs vor der Empfangszeit beginnt und endet, wenn der Wert des wenigstens einen Parameters erneut den Schwellenwert unterschreitet.

9. Vorrichtung nach einem der Ansprüche 5, 7 und 8, wobei die Phasenleitung 4 Leiter umfasst.

## Claims

1. A method for locating an event occurring along a phase line on a section (1105) of an electrical energy transmission line, the phase line comprising n conductors (1001, 1002, 1003, 1004) electrically insulated from one another and short-circuited between themselves at two extremities of the section (1105), the method comprising the steps of:
a) monitoring a parameter on one of the n conductors (1001, 1002, 1003, 1004) of the phase line, at one of the extremities of the section (1105) without a ground reference, said parameter being representative of current operational conditions of the phase line and having a known propagation speed in the conductor (1001, 1002, 1003, 1004);
b) generating an event detection signal at the extremity of the section (1105) each time the parameter has a value exceeding a threshold, and storing a reception time when the detection signal is generated;
c) transmitting a signal representative of a geographic location of the extremity of the section (1105); and
d) geographically locating the event along the section (1105) once two consecutive detection signals are generated from the signal representative of the geographic location of step c), and from the reception times associated with two consecutive detection signals.

2. The method according to claim 1, wherein the step of monitoring a parameter on one of the n conductors (1001, 1002, 1003, 1004) of the phase line is carried out at a sampling frequency of at least 1 MHz.

3. The method according to any one of claims 1 and 2, wherein in step a), data on the parameter are continually stored during a predetermined window of time, and in step b), after the generation of the detection signal, the data produced in step a) are kept in memory only for a period of time starting 100 µs before the reception time, and ending when the value of the parameter passes below the threshold again.

4. The method according to any one of claims 1 to 3, wherein said phase line comprises 4 conductors (1001, 1002, 1003, 1004).

5. An apparatus (1100) for locating an event occurring along a phase line on a section (1105) of an electrical energy transmission line, the phase line comprising n conductors (1001, 1002, 1003, 1004) electrically insulated from one another and short-circuited between themselves at two extremities of the section (1105), the apparatus being located at one of the extremities of the section (1105) and comprising:
a monitoring device (570) of at least one parameter on one of the n conductors (1001, 1002, 1003, 1004) of the phase line without a ground reference, said at least one parameter being representative of current operational conditions of the phase line and having a known propagation speed in the conductor (1001, 1002, 1003, 1004);
a device configured for generating a detection signal of the event at the extremity of the section (1105) each time said at least one parameter has a value that exceeding a threshold, and for storing a reception time when the detection signal is generated;
a device (570) configured for transmitting a signal representative of a geographic location of said extremity of the section (1105); and
a device (570) configured for geographically locating the event along the section (1105) once two consecutive detection signals are generated, from the signal representative of the geographic location, and from the reception times associated with two consecutive detection signals.

6. A system comprising two apparatuses (1100, 1110), each apparatus as claimed in claim 5, a first (1100) of said two apparatuses being located on a first section (1105), the second (1110) of said two apparatuses being located on a second section (1115) adjacent to the first section (1105), said second apparatus being located at one extremity of the second section (1115) adjacent to the extremity of the first section (1105) where the first apparatus (1100) is located.

7. The apparatus (1100) according to claim 5, wherein said monitoring device (570) is capable of operating at a sampling frequency of at least 1 MHz to monitor said at least parameter representative of operational conditions.

8. The apparatus (1100) according to any one of claims 5 and 7, said monitoring device (570) comprising means four continuously storing data on the parameter during a predetermined time window, and a memory for storing in memory only the data over a period of time starting 100 µs before the reception time and ending when the value of said at least one parameter passes below the threshold again.

9. The apparatus according to any one of claims 5, 7 and 8, said phase line comprising 4 conductors.
